# EUROPEAN PATENT APPLICATION

(11) **EP 4 661 084 A1**
(43) Date of publication of application: **10.12.2025**
(21) Application number: 24781275.3
(22) Date of filing: 28.03.2024
(51) Int. Cl.: H01L 33/58, H01L 33/62, H01L 33/52, H01L 33/48, H01L 25/075

(54) **LIGHT-EMITTING DEVICE AND DISPLAY DEVICE COMPRISING SAME**

(30) Priority: 31.03.2023 US 202363456120 P; 14.07.2023 US 202363526710 P; 18.07.2023 US 202363527419 P; 26.03.2024 US 202418616758
(71) Applicant: Seoul Viosys Co., Ltd., Ansan-si, Gyeonggi-do 15429 (KR)
(72) Inventor: KO, Mi So, Ansan-Si Gyeonggi-do 15429 (KR); CHOI, Eun Mi, Ansan-Si Gyeonggi-do 15429 (KR)
(74) Representative: Stolmár & Partner Patentanwälte PartG mbB
(86) International application number: PCT/KR2024/003991
(87) International publication number: WO 2024/205285

(57) **Abstract**

The present disclosure relates to a light emitting apparatus and a display apparatus including the same, more particularly to a light emitting apparatus including a light emitting device and a display apparatus including the same.

The light emitting apparatus (100) includes a substrate (110), at least one light emitting device (120) disposed on one surface of the substrate (110), and a molding layer (130) covering at least a region of the light emitting device (120), and further includes a first microelement (140) disposed above the light emitting device (120), wherein the first microelement (140) includes a curved surface (U) formed in at least a region of at least one of upper and lower surfaces thereof.

## Description

### [Technical Field]

The present disclosure relates to a light emitting apparatus and a display apparatus including the same, and more particularly to a light emitting apparatus including a light emitting device and a display apparatus including the same.

### [Background Art]

In recent years, nitride semiconductors have been widely used as a base material for light emitting devices, such as light emitting diodes. Since nitride semiconductors can have various bandgap energies depending on the composition ratio of group III elements, it is possible to realize light in various wavelength bands by controlling the composition of elements, such as Al, Ga, In, and the like.

A multi-quantum well structure (MQW) may be used as an active layer structure and emission wavelengths of a light emitting device may be determined according to the composition ratio of the nitride semiconductors in well layers of the multi-quantum well structure.

Typically, light emitting diodes may be utilized in the form of a light emitting diode package in which a light-emitting diode chip is mounted on a substrate, such as a printed circuit board (PCB) and the like, which includes an interconnection layer and an insulating layer.

### [Disclosure]

### [Technical Problem]

Embodiments of the present disclosure provide a light emitting apparatus and a display apparatus including the same, which can improve luminous intensity through improvement in light extraction efficiency and can improve color contrast to realize a clear image.

### [Technical Solution]

In accordance with one aspect of the present disclosure, a light emitting apparatus (100) includes a substrate (110), at least one light emitting device (120) disposed on one surface of the substrate (110), and a molding layer (130) covering at least a region of the light emitting device (120).

The light emitting apparatus (100) may further include a first microelement (140) disposed above the light emitting device (120).

The first microelement (140) may include a curved surface (U) formed in at least a region of at least one of an upper surface and a lower surface thereof.

In one embodiment, the first microelement (140) may include a plurality of guide portions (242) corresponding to an upper portion of the light emitting device (120) and forming the curved surface (U).

In one embodiment, the first microelement (140) may further include a connecting portion (244) connecting adjacent guide portions (242) to each other.

In accordance with another aspect of the present disclosure, a light emitting apparatus (100) includes a substrate (110), a plurality of light emitting devices (120) disposed on one surface of the substrate (110), a first microelement (140) disposed above the plurality of light emitting devices (120), and a light control layer (270, 280, 290) disposed between adjacent light emitting devices (120), wherein the first microelement (140) may include a curved surface (U) formed in at least a region of at least one of an upper surface and a lower surface thereof.

In accordance with a further aspect of the present disclosure, a light emitting apparatus (100) includes a substrate (110), a plurality of light emitting devices (120) disposed on one surface of the substrate (110), a first microelement (140) disposed above the plurality of light emitting devices (120), and a collimator (135) disposed between upper surfaces of the light emitting devices (120) and a lower surface of the first microelement (140) and including a curved surface (U), wherein an upper surface of the first microelement (140) may be a flat surface (F).

### [Advantageous Effects]

Embodiments of the present disclosure provide a light emitting apparatus and a display apparatus including the same, which can improve luminous intensity through improvement in light extraction efficiency and can improve color contrast to provide a clear image.

### [Description of Drawings]

FIG. 1 is a schematic plan view of a light emitting apparatus according to an embodiment of the present disclosure.
FIG. 2A is a cross-sectional view taken along line I-I' of FIG. 1.
FIG. 2B is a cross-sectional view taken along line II-II' of FIG. 1.
FIG. 3 is a sectional view of a light emitting apparatus according to one embodiment of the present disclosure.
FIG. 4 is a sectional view of a light emitting apparatus according to another embodiment of the present disclosure.
FIG. 5A and FIG. 5B are sectional views of a light emitting apparatus according to a further embodiment of the present disclosure.
FIG. 6A, FIG. 6B, and FIG. 6C are plan views of light emitting apparatuses according to embodiments of the present disclosure.
FIG. 7 is a sectional view of a light emitting apparatus according to yet another embodiment of the present disclosure.
FIG. 8 is a sectional view of a light emitting apparatus according to yet another embodiment of the present disclosure.
FIG. 9 is a sectional view of a light emitting apparatus according to yet another embodiment of the present disclosure.
FIG. 10 is a sectional view of a light emitting apparatus according to yet another embodiment of the present disclosure.
FIG. 11 is a sectional view of a light emitting apparatus according to yet another embodiment of the present disclosure.
FIG. 12 is a sectional view of a light emitting apparatus according to yet another embodiment of the present disclosure.
FIG. 13 is a sectional view of a light emitting apparatus according to yet another embodiment of the present disclosure.
FIG. 14 is a plan view of a light emitting apparatus according to yet another embodiment of the present disclosure.
FIG. 15 is a sectional view of a light emitting apparatus according to yet another embodiment of the present disclosure.
FIG. 16 is a sectional view of a light emitting apparatus according to yet another embodiment of the present disclosure.
FIG. 17 is a sectional view of a light emitting apparatus according to yet another embodiment of the present disclosure.
FIG. 18 is a sectional view of a light emitting apparatus according to yet another embodiment of the present disclosure.
FIG. 19 is a sectional view of a light emitting apparatus according to yet another embodiment of the present disclosure.
FIG. 20 is a sectional view of a light emitting apparatus according to yet another embodiment of the present disclosure.
FIG. 21 is a sectional view of a light emitting apparatus according to yet another embodiment of the present disclosure.
FIG. 22 is a sectional view of a light emitting apparatus according to yet another embodiment of the present disclosure.
FIG. 23A, FIG. 23B, FIG. 23C, and FIG. 23D are a plan view and perspective views of various display apparatuses according to exemplary embodiments of the present disclosure.

### [Best Mode]

The present disclosure may be variously modified and realized in many different forms, and thus specific embodiments will be exemplified in the drawings and described in detail herein below. However, in the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," or the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), or the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "includes," "including," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, or the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

One embodiment of the present disclosure provides a light emitting apparatus 100 including a substrate 110, at least one light emitting device 120 disposed on one surface of the substrate 110, and a molding layer 130 covering at least a region of the light emitting device 120. Hereinafter, embodiments of the present disclosure will be described in more detail with reference to the accompanying drawings.

The light emitting device 120 may be a light emitting diode including a substrate 11 and a light emitting structure 12 disposed on the substrate 11.

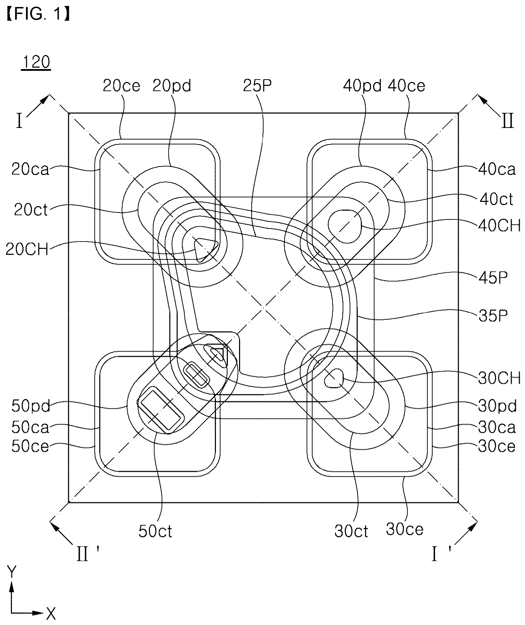

Referring to FIG. 1, the light emitting device 120 may be formed by unifying a plurality of arrays of light emitting structures 12 formed on the substrate 11. The light emitting device 120 may be mounted on a circuit board 110 to form the light emitting apparatus 100, which will be described below.

The substrate 11 is a growth substrate on which nitride semiconductors can be grown, and may include, for example, a heterogeneous substrate, such as a sapphire substrate, a gallium arsenide substrate, a silicon substrate, a silicon carbide substrate, or a spinel substrate, and may also include a homogeneous substrate, such as a gallium nitride substrate, an aluminum nitride substrate, and the like. The substrate 11 may be removed after growth of semiconductor layers.

The substrate 11 may include a light-transmissive insulating material to transmit light. However, it should be understood that the present disclosure is not limited thereto. Alternatively, the substrate 11 may be translucent or partially transparent to transmit only light having certain wavelengths or to transmit only a fraction of light having certain wavelengths.

The area of the substrate 11 may define an area of the light emitting device 100. In one embodiment, the substrate 11 may have the same area as or greater than the light emitting structure 12.

The substrate 11 may have an area of about 60,000 µm² or less, specifically 30,000 µm², more specifically 10,000 µm² or less. The substrate 11 may have a thickness of 30 µm to 180 µm, specifically 30 µm to 100 µm.

In one embodiment, the substrate 11 may have an area of 225 × 225 µm² and a thickness of 50 µm. As the area-to-thickness ratio of the substrate 11 decreases, the ratio of light extracted in a direction horizontal to a back surface of the substrate 11, that is, through a side surface thereof, can be reduced and the ratio of light extracted therefrom in a direction perpendicular to the back surface of the substrate 11 can be increased relative to the total quantity of light extracted outside from the light emitting device 120. In particular, as the thickness of the substrate 11 is reduced, light emitted from the light emitting structure 12 can be better emitted in the direction perpendicular to the back surface of the substrate 11. Accordingly, the light emitting device 120 can relieve color differences depending on viewing angle by reducing deviation of light extracted from the light emitting device 120.

The light emitting structure 12 is a light emitting diode disposed on the substrate 11 and may have various configurations.

For example, the light emitting structure 12 may be a stacked light emitting diode including first to third light emitting stacks 2, 3, 4, as shown in FIG. 1 to FIG. 2B. In this embodiment, the light emitting device 120 may include a first connection electrode 20ce, a second connection electrode 30ce, a third connection electrode 40ce, and a fourth connection electrode 50ce formed on the first to third light emitting stacks 2, 3, 4, and a protective layer 90 surrounding the connection electrodes 20ce, 30ce, 40ce, 50ce.

The first, second and third light emitting stacks 2, 3, 4 may emit light with different peak wavelengths. Specifically, light emitted from the first light emitting stack 2 may pass through the second and third light emitting stacks 3, 4.

The light emitting stack 2, 3 or 4 placed away from the substrate 11 may emit light having a longer wavelength than a light emitting stack 2, 3 or 4 near the substrate 11, thereby reducing light loss. For example, the first light emitting stack 2 may emit light having a longer wavelength than the second and third light emitting stacks 3, 4 and the second light emitting stack 3 may emit light having a longer wavelength than the third light emitting stack 4. Specifically, the first light emitting stack 2 may emit red light, the second light emitting stack 3 may emit green light, and the third light emitting stack 4 may emit blue light.

In another embodiment, in order to adjust a color mixing ratio of the first, second and third light emitting stacks 2, 3, 4, the second light emitting stack 3 may emit light having a shorter wavelength than the third light emitting stack 4. Accordingly, the luminous intensity of the second light emitting stack 3 can be reduced, the luminous intensity of the third light emitting stack 4 can be increased, and the luminous intensity ratio of light emitted from the first, second and third light emitting stacks 2, 3, 4 can be controlled.

For example, the first light emitting stack 2 may be configured to emit red light, the second light emitting stack 3 may be configured to emit blue light, and the third light emitting stack 4 may be configured to emit green light. Accordingly, the luminous intensity of blue light can be relatively reduced and the luminous intensity of green light can be relatively increased. Thus, the luminous intensity ratio of red, green and blue light can be adjusted to about 3:6:1.

Further, the first, second and third light emitting stacks 2, 3, 4 may have an light emission area of 10,000 µm² or less, specifically 4,000 µm², more specifically 2,500 µm² or less. Furthermore, the light emitting area may be increased with decreasing distance to the substrate 11 and the luminous intensity of green light may be further increased by disposing the third light emitting stack 4 configured to emit green light at a place closest to the substrate 11.

Although the light emitting device 120 including three light emitting stacks 2, 3, 4 is illustrated, the present disclosure is not limited to a specific number of light emitting stacks. For example, in some embodiments, the light emitting device 120 may include two or more light emitting stacks. Herein, the light emitting device 120 including three light emitting stacks 2, 3, 4 according to the embodiment will be described by way of example.

In the following description, the second light emitting stack 3 will be described as emitting shorter wavelength light, for example, blue light, than the third light emitting stack 4. However, it should be noted that the second light emitting stack 3 may emit longer wavelength light, such as green light, than the third light emitting stack 4.

The first light emitting stack 2 may include a first LED stack 20 and a first upper contact electrode 25p, and may further include a first lower contact electrode 21n.

The first LED stack 20 may include a first conductivity-type semiconductor layer 21, an active layer 23, and a second conductivity-type semiconductor layer 25. According to one embodiment, the first LED stack 20 may include a semiconductor material emitting red light, for example, AlGaAs, GaAsP, AlGaInP, and GaP, without being limited thereto.

The first upper contact electrode 25p forms ohmic contact with the second conductivity-type semiconductor layer 25. The first upper contact electrode 25p may be formed of a transparent conductive oxide, for example, indium tin oxide (ITO), without being limited thereto. Alternatively, for example, the first upper contact electrode 25p may also be a metal layer capable of forming ohmic contact with the second conductivity-type semiconductor layer 25. The first upper contact electrode 25p may be formed of, for example, ITO to a thickness of 200 nm to 400 nm.

The first lower contact electrode 21n may be disposed on the first conductivity-type semiconductor layer 21 and may form ohmic contact with the first conductivity-type semiconductor layer 21. The first upper contact electrode 25p, the active layer 23, and the second conductivity-type semiconductor layer 25 may be subjected to patterning to expose an upper surface of the first conductivity-type semiconductor layer 21. The first lower contact electrode 21n may be formed on the exposed upper surface of the first conductivity-type semiconductor layer 21.

The first lower contact electrode 21n may have a monolayer structure or a multilayer structure, and may include Al, Ti, Cr, Ni, Au, Ag, Sn, W, Cu, or alloys thereof, for example, Au-Te alloys or Au-Ge alloys, without being limited thereto.

In this embodiment, the first conductivity-type semiconductor layer 21 may be disposed closer to the substrate 11 than the second conductivity-type semiconductor layer 25. Light generated by the active layer 23 may be emitted through the first conductivity-type semiconductor layer 21 toward the substrate 11. Since light generated by the first light emitting stack 2 is emitted outside through the second light emitting stack 3 and the third light emitting stack 4, light loss can occur.

In this embodiment, the first conductivity-type semiconductor layer 21 may include a roughened surface 21r, which can improve extraction efficiency of light generated by the active layer 23. A recessed portion of the roughened surface 21r may have a depth D in the range of about 0.1 µm to 0.9 µm. The roughened surface 21r may be disposed to face the substrate 11 and may contact an adhesive layer 61. The roughened surface 21r may be formed through wet or dry etching and protrusions or depressions may have a lateral inclination angle in the range of 35 degrees to 65 degrees.

Furthermore, as will be described below, a second insulating layer 83 may include a distributed Bragg reflector (DBR) and may act to increase emission luminance of the first light emitting stack 2 by reflecting light generated by the active layer 23. The DBR of the second insulating layer 83 may be formed to have a high reflectivity of about 80% or more with respect to light in the wavelength range of 600 nm to 650 nm.

The second light emitting stack 3 may include a second LED stack 30 and a second lower contact electrode 35p, and may further include a second upper contact electrode 31n.

The second LED stack 30 may include a first conductivity-type semiconductor layer 31, an active layer 33, and a second conductivity-type semiconductor layer 35. In one embodiment, the second LED stack 30 may include a semiconductor material that emits blue light, for example, GaN, InGaN, ZnSe, or the like, without being limited thereto. The second lower contact electrode 35p may be disposed under the second conductivity-type semiconductor layer 35 of the second LED stack 30 and may form ohmic contact with the second conductivity-type semiconductor layer 35. The second lower contact electrode 35p may be formed of a material transparent to light, for example, red light and blue light, generated by the first light emitting stack 2 and the third light emitting stack 3, and may be formed of a transparent conductive oxide, for example, ITO or ZnO. The second lower contact electrode 35p may be formed of, for example, ITO to a thickness of 200 nm to 400 nm.

In this embodiment, the first conductivity-type semiconductor layer 31 of the second LED stack 30 may be disposed to face the first conductivity-type semiconductor layer 21 of the first LED stack 20. Thus, an upper surface of the first conductivity-type semiconductor layer 31 may be exposed independent of the active layer 33 and the second conductivity-type semiconductor layer 35, and the second upper contact electrode 31n may be formed on the exposed surface of the first conductivity-type semiconductor layer 31. The second upper contact electrode 31n may be omitted.

The third light emitting stack 4 may include a third LED stack 40 and a third upper contact electrode 45p, and may further include a third lower contact electrode 41n.

The third LED stack 40 may include a first conductivity-type semiconductor layer 41, an active layer 43, and a second conductivity-type semiconductor layer 45. In one embodiment, the third LED stack 40 may include a semiconductor material emitting green light, for example, GaN, InGaN, GaP, AlGaInP, AlGaP, or the like. The third upper contact electrode 45p may be disposed on the second conductivity-type semiconductor layer 45 of the third LED stack 40 and may form ohmic contact with the second conductivity-type semiconductor layer 45. The third upper contact electrode 45p may be formed of a material transparent to light, for example, red light and blue light, generated by the first light emitting stack 2 and the third light emitting stack 3, and may be formed of a transparent conductive oxide, for example, ITO or ZnO. The third upper contact electrode 45p may be formed of, for example, ITO to a thickness of 200 nm to 400 nm.

In this embodiment, the second conductivity-type semiconductor layer 45 of the third LED stack 40 faces the second conductivity-type semiconductor layer 35 of the second LED stack 30. That is, the second LED stack 30 and the third LED stack 40 are arranged such that the second conductivity-type semiconductor layers 35, 45 with the same polarity face each other. The second LED stack 30 and the first LED stack 20 are also arranged such that the first conductivity-type semiconductor layers 21, 31 with the same polarity face each other.

In embodiments of the present disclosure, each of the first conductivity-type semiconductor layers 21, 31, 41 and the second conductivity-type semiconductor layers 25, 35, 45 of the first, second and third LED stacks 20, 30, 40 may have a monolayer structure or a multilayer structure, and may include super-lattice layers. Further, the active layers 23, 33, 43 of the first, second and third LED stacks 20, 30, 40 may have a single quantum well structure or a multi-quantum well structure.

The overall thickness of the first light emitting stack 2 to the third light emitting stack 4 including the first, second and third LED stacks 20, 30, 40 may range, for example, from about 10 µm to about 30 µm. Preferably, the overall thickness of the first to third light emitting stacks ranges from about 15 µm to about 25 µm, more preferably from about 18 µm to about 22 µm, without being limited thereto.

In general, the substrate 11 may be thicker than the total thickness of the first, second and third light emitting stacks 2, 3, 4. In one embodiment, the ratio of the thickness of the substrate 11 to the total thickness of the first, second and third light emitting stacks 2, 3, 4 may be in the range of 1.5:1 to 6:1, specifically 1.5:1 to 4:1, more specifically 2.27:1 to 2.78:1. As the thickness ratio decreases, that is, as the ratio of the thickness of the substrate 11 to the total thickness of the first, second and third light emitting stacks 2, 3, 4 is decreased, the ratio of light extracted through the side surface of the substrate 11 to light emitted from the light emitting device 120 decreases and the ratio of light extracted through the substrate 11 in the direction perpendicular to the back surface of the substrate 11 increases. Accordingly, the light emitting device 120 can relieve a color difference depending on viewing angle by reducing a difference in emission patterns of light extracted from the light emitting device 100.

The thickness of the substrate 11 may be greater than the total thickness of the first, second and third LED stacks 20, 30, 40 or may be greater than the thickness of a region of the protective layer 90 disposed between the connection electrodes 20ce, 30ce, 40ce, 50ce and vertically overlapping the first, second and third LED stacks 20, 30, 40. In addition, the thickness of the substrate 11 may also be thinner than the thickness of a region of the protective layer 90 surrounding the outermost side surface of the connection electrodes 20ce, 30ce, 40ce, 50ce. This structure can provide effective improvement in light deviation depending on viewing angle.

Each of the first upper contact electrode 25p, the second lower contact electrode 35p and the third upper contact electrodes 25p, 35p, 45p may include a transparent conductive material that transmits light. For example, the contact electrodes 25p, 35p, 45p may be formed of a transparent conductive oxide (TCO). The transparent conductive oxide (TCO) may include SnO, InO₂, ZnO, ITO, ITZO, and the like, without being limited thereto.

A first bonding layer 61 may be disposed between the first LED stack 20 and the second LED stack 30 and a second bonding layer 63 may be disposed between the second LED stack 30 and the third LED stack 40. The first bonding layer 61 may adjoin the first conductivity-type semiconductor layer 21 of the first LED stack 20 and the first conductivity-type semiconductor layer 31 of the second LED stack 30. The first bonding layer 61 may include regions having different thicknesses, that is, a thick region and a thin region. The second bonding layer 61 may have a thickness less than the maximum thickness of the thick region of the first bonding layer 61 and greater than the minimum thickness of the thin region.

The second bonding layer 63 may be formed to a thickness of, for example, 1.8 µm to 2.2 µm. The first and second bonding layers 61, 63 may include a nonconductive material that transmits light. For example, the first and second bonding layers 61, 63 may include optically clear adhesives (OCAs), for example, epoxy, silicone, polyimide, SU8, spin-on-glass (SOG), and benzocyclobutene (BCB), without being limited thereto. The first bonding layer 61 and the second bonding layer 63 need not be identical to each other and may be formed of different materials, for example, materials having different indexes of refraction, melting points, or transmittances.

A first stress relieving layer 51 may be disposed on the second bonding layer 63 to be placed between the second bonding layer 63 and the second LED stack 30. A second stress relieving layer 53 may be disposed under the second bonding layer 63 and may be disposed between the second bonding layer 63 and the third LED stack 40. Each of the first and second stress relieving layers 51, 53 may be formed to a thickness of, for example, 50 nm to 150 nm. The first and second stress relieving layers 51, 53 may include an insulating material. For example, the first and second stress relieving layers 51, 53 may include organic or inorganic insulating materials, for example, polyimides, SiO₂, SiNx, and Al₂O₃, for example, SiO₂, without being limited thereto.

The first and second stress relieving layers 51, 53 may be disposed between the LED stacks when the first, second and third LED stacks 20, 30, 40 are vertically stacked. More specifically, the substrate 11 can be bent upon sequential bonding of the second LED stack 30 and the first LED stack 20 on the third LED stack 40, causing cracks between the LED stacks 20, 30, 40. The first and second stress relieving layers 51, 53 between the LED stacks 20, 30, 40 may relieve bending of the substrate 11, thereby preventing defects, such as cracks between the LED stacks 20, 30, 40.

The first insulating layer 81 and the second insulating layer 83 may be disposed on at least part of upper and side surfaces of the first, second and third LED stacks 20, 30, 40. At least one of the first and second insulating layers 81, 83 may include various organic or inorganic insulating materials, for example, polyimide, SiO₂, SiNx, Al₂O₃, or the like. Further, at least one of the first and second insulating layers 81, 83 may include a monolayer structure or a multilayer structure, and may include a distributed Bragg reflector (DBR) as an example of the multilayer structure. In one embodiment, the first insulating layer 81 may be formed of SiO₂ and the second insulating layer 83 may be a distributed Bragg reflector (DBR). The first insulating layer 81 may be thinner than the second insulating layer 83 and may have a thickness of, for example, about 0.4 µm. The second insulating layer 83 may have a thickness of about 1.5 µm to 3 µm.

The distributed Bragg reflector (DBR) of the second insulating layer 83 may include first material layers having a first index of refraction and second material layers having a second index of refraction. The first material layers may have a low index of refraction and the second material layers may have a high index of refraction. "Low index of refraction" and "high index of refraction" represent a difference in index of refraction relative to the first material layers and the second material layers. In one embodiment, the first material layers may be SiO₂ layers and the second material layers may be TiO₂ layers. SiO₂ of the first material layers has an index of refraction of about 1.47 and TiO₂ of the second material layers has an index of refraction of about 2.41. However, in the present disclosure, the first material layers and the second material layers are not limited to SiO₂ and TiO₂. For example, the first and second material layers may be formed of Si₃N₄, MgF₂, Nb₂O₅, ZnS, ZrO₂, ZnO, compound semiconductors, or the like. However, the difference in index of refraction between the first and second material layers may be greater than 0.5.

The distributed Bragg reflector (DBR) may be formed by repeatedly stacking pairs of first and second material layers multiple times. Generally, material layers having a high index of refraction have a higher absorption rate than material layers having a low index of refraction. Thus, it is possible to reduce light loss due to light absorption by forming the second material layers having a high index of refraction to a smaller optical thickness than the first material layers having a low index of refraction. Accordingly, each of the first material layers, that is, SiO₂ layers, may be formed to a greater thickness than each of the second material layers, that is, TiO₂ layers.

In addition, the first layer and the last layer of the distributed Bragg reflector (DBR) may be SiO₂ layers. The SiO₂ layer used as the first layer of the distributed Bragg reflector (DBR) can strengthen adhesion to the first insulating layer 81 and the SiO₂ layer used as the last layer can protect the distributed Bragg reflector (DBR) while strengthening adhesion to the protective layer 90 and the connection electrodes 20ce, 30ce, 40ce, 50ce described below.

According to one embodiment, the distributed Bragg reflector (DBR) applied to the second insulating layer 83 may have a reflectivity of 80% or more, specifically 90% or more, more specifically 95% or more in the wavelength range of 600 nm to 650 nm, and thus can reflect light emitted from the light emitting device 120, particularly light emitted from the first light emitting stack 2, with high reflectivity. The distributed Bragg reflector (DBR) may include, for example, 16 to 25 pairs of the first and second material layers, without being limited thereto. The distributed Bragg reflector may have a thickness of 1.5 µm to 3 µm. The distributed Bragg reflector (DBR) may have a reflectivity of 90% or greater in the wavelength range of 410 nm to 700 nm.

The second insulating layer 83 can improve light extraction efficiency by reflecting light emitted from the first, second and third LED stacks 20, 30, 40. Further, the distributed Bragg reflector (DBR) composed of multiple layers may form a light cavity to improve straightness of extracted light while reducing deviation in emission patterns of blue light, green light and red light to relieve a color difference depending on the viewing angle.

The first insulating layer 81 may be etched to form contact holes 20CH, 30CH, 40CH, 50CH described below. The first insulating layer 81 may be formed as a SiO₂ monolayer to facilitate an etching process. Accordingly, it is possible to secure a uniform thickness of the distributed Bragg reflector without damage to the lower contact electrodes 25p, 35p, 45p under the first insulating layer 81, thereby stably maintaining electrical properties. Furthermore, the distributed Bragg reflector (DBR) of the second insulating layer 83 can cause diffuse reflection of light extracted through the side surfaces of the first, second and third light emitting stacks 2, 3, 4, thereby improving light extraction efficiency.

When the first insulating layer 81 is formed of a dielectric layer having a low index of refraction, such as SiO₂, the first insulating layer 81 may constitute an omnidirectional reflector together with the first to third LED stacks 20, 30, 40 and the electrode pads 20pd, 30pc, 40pd, 50pd covering the first insulating layer 81.

Each of the first, second and third LED stacks 20, 30, 40 may be independently driven. In one embodiment, a common voltage may be applied to the first conductivity-type semiconductor layers 21, 31, 41 of the first, second and third LED stacks 20, 30, 40 and an individual light emission signal may be applied to each of the second conductivity-type semiconductor layers 25, 35, 45. In other embodiments, an individual light emission signal may be applied to each of the first conductivity-type semiconductor layers 21, 31, 41 of the first, second and third LED stacks 20, 30, 40 and a common voltage may be applied to the second conductivity-type semiconductor layers 25, 35, 45. For example, the first conductivity-type semiconductor layers 21, 31, 41 of the LED stacks 20, 30, 40 may be n-type and the second conductivity-type semiconductor layers 25, 35, 45 thereof may be p-type. In this case, a common voltage may be applied to the first conductivity-type semiconductor layers 21, 31, 41 and an individual light emission signal may be applied to each of the second conductivity-type semiconductor layers 25, 35, 45, or vice versa. When the first, second and third LED stacks 20, 30, 40 are vertically stacked one above another, the third LED stack 40 may have a reversed stacking sequence, as compared to the first and second LED stacks 20, 30. That is, the second conductivity-type semiconductor layer 45, for example, a p-type semiconductor layer 45, of the third LED stack 40 may be disposed on the active layer 43 and the second conductivity-type semiconductor layer 35 of the second LED stack 30 may be disposed under the active layer 33. The stacking sequence of the third LED stack 40 opposite to the stacking sequence of the second LED stack 30 can simplify the process of manufacturing the light emitting device 120. In this embodiment, the first conductivity-type semiconductor layer and the second conductivity-type semiconductor layer are described as being n-type and p-type, respectively. However, it should be understood that the present disclosure is not limited thereto and the first and second conductivity-type semiconductor layers may be p-type and n-type, respectively.

According to the embodiment shown in the drawings, the light emitting device 120 may include a first pad electrode 20pd, a second pad electrode 30pd, a third pad electrode 40pd, and a fourth pad electrode 50pd. The second conductivity-type semiconductor layers 25, 35, 45 of the LED stacks 20, 30, 40 may be connected to the first pad electrode 20pd, the second pad electrode 30pd, and the third pad electrode 40pd, respectively, to receive corresponding light emitting signals. On the other hand, the first conductivity-type semiconductor layers 21, 31, 41 of the LED stacks 20, 30, 40 may be connected to the fourth pad electrode 50pd to receive a common voltage applied from the outside. In this way, each of the first, second and third LED stacks 20, 30, 40 may be independently driven while having a common n-type electrode to which the common voltage is applied, without being limited thereto.

The first electrode pad 20pd may be connected to the first upper contact electrode 25p through a first contact hole 20CH defined through the first insulating layer 81 and may also be electrically connected to the second conductivity-type semiconductor layer 25. The first electrode pad 20pd may be disposed between the first insulating layer 81 and the second insulating layer 83 and may at least partially overlap the first and second insulating layers 81, 83.

The second electrode pad 30pd may be connected to the second lower contact electrode 35p through a second contact hole 30CH defined through the first insulating layer 81 and may also be electrically connected to the second conductivity-type semiconductor layer 35. The second electrode pad 30pd may be disposed between the first insulating layer 81 and the second insulating layer 83 and may at least partially overlap the first and second insulating layers 81, 83.

The third electrode pad 40pd may be connected to the third upper contact electrode 45p through a third contact hole 40CH defined through the first insulating layer 81 and may also be electrically connected to the second conductivity-type semiconductor layer 45. The third electrode pad 40pd may be disposed between the first insulating layer 81 and the second insulating layer 83 and may at least partially overlap the first and second insulating layers 81, 83.

The fourth electrode pad 50pd is electrically connected in common to the first conductivity-type semiconductor layers 21, 31, 41 of the first, second and third LED stacks 20, 30, 40. For example, the fourth electrode pad 50pd may be electrically connected to the first lower contact electrode 21n, the second upper contact electrode 31n and the third lower contact electrode 41n disposed on the first conductivity-type semiconductor layers 21, 31, 41 of the first, second and third LED stacks 20, 30, 40 through the first sub-contact hole 50CHa, the second sub-contact hole 50CHb and the third sub-contact hole 50CHc defined through the first insulating layer 81. At least one of the first lower contact electrode 21n, the second upper contact electrode 31n, and the third lower contact electrode 41n may be omitted and the fourth electrode pad 50pd may be electrically connected directly to the first conductivity-type semiconductor layer 21 of the first LED stack 20, may be electrically connected to the first conductivity-type semiconductor layer 31 of the second LED stack 30 through the second sub-contact hole 50CHb, or may be electrically connected to the first conductivity-type semiconductor layer 41 of the third LED stack 40 through the third sub-contact hole 50CHc.

According to one embodiment, the electrode pads 20pd, 30pd, 40pd, 50pd may be formed at various locations. For example, when the light emitting device 100 has a square upper surface as shown in FIG. 1A, the electrode pads 20pd, 30pd, 40pd, 50pd may be disposed around each vertex of the square upper surface. However, it should be understood that the present disclosure is not limited thereto. Alternatively, the light emitting device 120 may be formed in various shapes and the electrode pads 20pd, 30pd, 40pd, 50pd may be formed at various locations depending on the shape of the light emitting device 120.

The first, second, third and fourth electrode pads 20pd, 30pd, 40pd, 50pd are spaced apart from one another and may be insulated. According to one embodiment, the first, second, third and fourth electrode pads 20pd, 30pd, 40pd, 50pd may cover at least part of side surfaces of the first, second and third LED stacks 20, 30, 40, respectively.

The first to fourth connection electrodes 20ce, 30ce, 40ce, 50ce may be formed in an elongated shape extending vertically from the substrate 11. The first connection electrode 20ce may be electrically connected to the first electrode pad 20pd through a first through-hole 20ct defined through the second insulating layer 83. The second connection electrode 30ce may be electrically connected to the second electrode pad 30pd through a second through-hole 30ct defined through the second insulating layer 83. The third connection electrode 40ce may be electrically connected to the third electrode pad 40pd through a third through-hole 40ct defined through the second insulating layer 83. The fourth connection electrode 50ce may be electrically connected to the fourth electrode pad 50pd through a fourth through-hole 50ct defined through the second insulating layer 83.

The first to fourth connection electrodes 20ce, 30ce, 40ce, 50ce may include metals, such as Cu, Ni, Ti, Sb, Mo, Co, Sn, Ag, or alloys thereof, without being limited thereto. For example, each of the first to fourth connection electrodes 20ce, 30ce, 40ce, 50ce may include two or more metal layers or a plurality of different metal layers to reduce stress due to the elongated shape of the first to fourth connection electrodes 20ce, 30ce, 40ce, 50ce. When the first to fourth connection electrodes 20ce, 30ce, 40ce, 50ce include Cu, an additional metal layer may be formed to suppress oxidation of Cu. Furthermore, the first to fourth connection electrodes 20ce, 30ce, 40ce, 50ce may include Cu/Ni/Sn. In this structure, Cu can prevent Sn from penetrating into the light emitting device 100 and also exhibits excellent thermal conductivity, whereby heat generated from the light emitting device 100 can be easily dissipated outside.

The first to fourth connection electrodes 20ce, 30ce, 40ce, 50ce may further include seed layers for forming metal layers during a plating process. The seed layers may be composed of, for example, a plurality of Ti/Cu layers.

The first to fourth connection electrodes 20ce, 30ce, 40ce, 50ce may have a flat upper surface, thereby facilitating electrical connection between external lines or circuit electrodes described below and the first, second and third LED stacks. According to one embodiment, when the light emitting device 100 includes micro-LEDs having a surface area of less than 10,000 µm², specifically less than 4,000 µm², more specifically less than 2,500 µm², the first to fourth connection electrodes 20ce, 30ce, 40ce, 50ce may overlap at least one of the first, second and third LED stacks 20, 30, 40. More specifically, the first to fourth connection electrodes 20ce, 30ce, 40ce, 50ce may overlap at least one step formed on the side surfaces of the first, second and third LED stacks 20, 30, 40. As such, since a lower surface of each of the first to fourth connection electrodes 20ce, 30ce, 40ce, 50ce has a larger contact area than an upper surface thereof, larger contact areas may be formed between the first to fourth connection electrodes 20ce, 30ce, 40ce, 50ce and the first, second and third LED stacks 20, 30, 40. Accordingly, the first to fourth connection electrodes 20ce, 30ce, 40ce, 50ce can be more stably formed on the first, second and third light emitting stacks 2, 3, 4. In addition, the connection electrodes 20ce, 30ce, 40ce, 50ce connected to the electrode pads 20pd, 30pd, 40pd, 50pd may occupy most of the area of the light emitting device 120, thereby providing a light emitting device 120 capable of efficiently dissipating generated heat. The connection electrodes 20ce, 30ce, 40ce, 50ce can also efficiently dissipate heat generated by the light emitting device 120 to the outside through the shortest path.

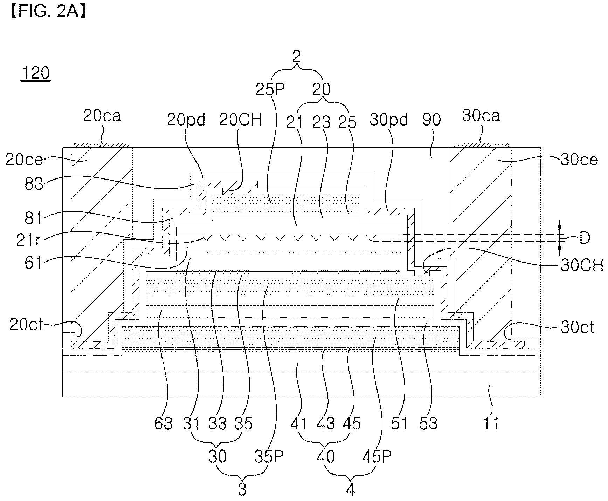

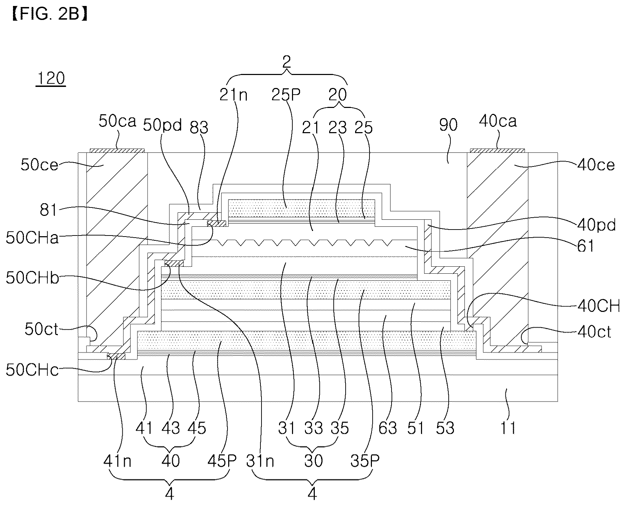

According to one embodiment, the protective layer 90 may be formed on the first, second and third light emitting stacks 2, 3, 4. More specifically, as shown in FIG. 2A and FIG. 2B, the protective layer 90 may be formed between the first to fourth connection electrodes 20ce, 30ce, 40ce, 50ce to cover at least part of the side surfaces of the first, second and third light emitting stacks 2, 3, 4 and the side surfaces of the first to fourth connection electrodes 20ce, 30ce, 40ce, 50ce.

The protective layer 90 may expose the side surfaces of the substrate 11, the first and second insulating layers 81, 83 and the third LED stack 40, as shown in the drawings. The protective layer 90 may be formed coplanar with the upper surfaces of the first to fourth connection electrodes 20ce, 30ce, 40ce, 50ce and may include an epoxy molding compound (EMC) or the like.

The protective layer 90 may be transparent or may be formed in various colors, such as black, white, or the like. The protective layer 90 may include a polyimide (PID). Here, the polyimide (PID) may be provided as a dry film rather than a liquid to increase flatness when applied to the first, second and third light emitting stacks 2, 3, 4. Further, the protective layer 90 may include a material having photosensitive properties. Accordingly, the protective layer 90 may provide a sufficient contact area to the light emitting device 120 to protect the first, second and third light emitting stacks 2, 3, 4 from external impact that can be applied thereto during a subsequent process while facilitating handling during a subsequent transfer step. Furthermore, the protective layer 90 can prevent light leakage through the side surfaces of the light emitting device 120, thereby preventing or suppressing interference of light emitted from adjacent light emitting devices.

Protective metal layers 20ca, 30ca, 40ca, 50ca may be further formed on the connection electrodes 20ce, 30ce, 40ce, 50ce. The protective metal layers 20ca, 30ca, 40ca, 50ca may be a plurality of multilayered metal layers and may be Ti/Ni/Au, without being limited thereto. The protective metal layers 20ca, 30ca, 40ca, 50ca may be formed on the upper surfaces of the first to fourth connection electrodes 20ce, 30ce, 40ce, 50ce and may be formed to have a narrower width than the first to fourth connection electrodes 20ce, 30ce, 40ce, 50ce. Accordingly, the protective metal layers 20ca, 30ca, 40ca, 50ca may have a narrower surface area than the first to fourth connection electrodes 20ce, 30ce, 40ce, 50ce. However, the present disclosure is not limited thereto and the protective metal layers 20ca, 30ca, 40ca, 50ca may be formed to have a greater width than the first to fourth connection electrodes 20ce, 30ce, 40ce, 50ce, and thus may be formed in a larger surface area.

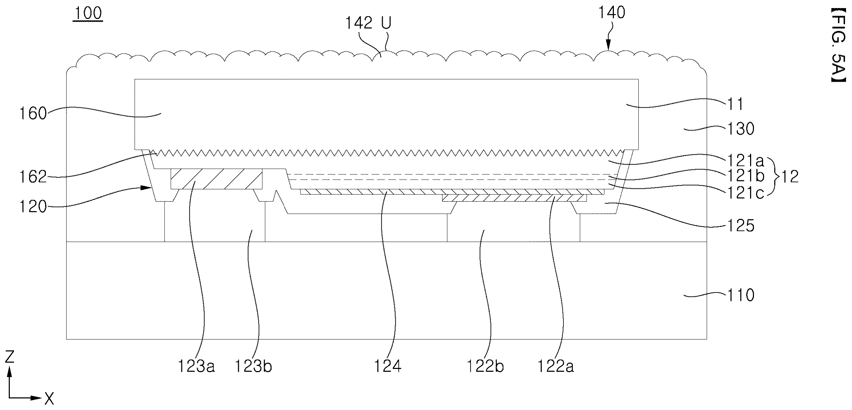

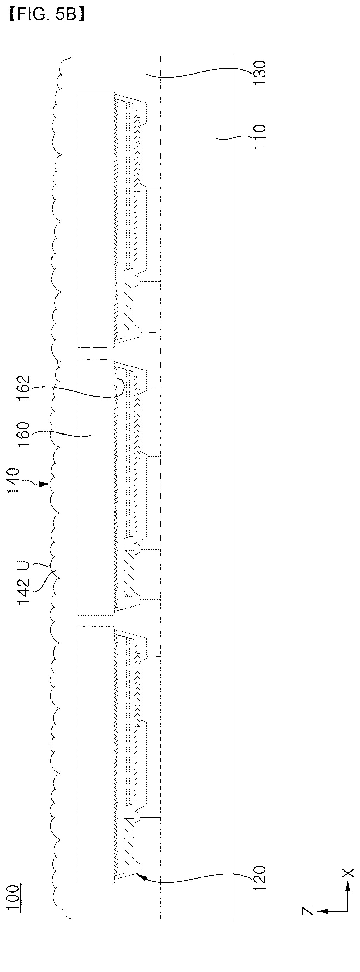

It will be apparent that the light emitting device 120 is not limited to the stacked light emitting diode including the first and third light emitting stacks 2, 3, 4, as shown in FIG. 1 to FIG. 2B, and may be modified into various structures, such as a vertical type, a horizontal type, a flip-chip type, and the like. For example, the light emitting device 120 may be a light emitting diode including semiconductor layers formed on the substrate 11, as shown in FIG. 5A and FIG. 5B.

Referring to FIG. 5A and FIG. 5B, the light emitting device 120 may include a first conductivity type semiconductor layer 121a, an active layer 121b, and a second conductivity type semiconductor layer 121c.

The first conductivity type semiconductor layer 121a may be a semiconductor layer grown on one surface of the substrate 11 and a buffer layer (not shown) may be further formed between the first conductivity type semiconductor layer 121a and the substrate 11.

The first conductivity type semiconductor layer 121a may include a phosphide or nitride semiconductor, such as (Al, Ga, In)P or (Al, Ga, In)N, and may be formed on the substrate 11 by a growth method, such as MOCVD, MBE, HVPE, or the like. Further, the first conductivity type semiconductor layer 121a may be an n-type semiconductor layer doped with at least one dopant, such as Si, C, Ge, Sn, Te, Pb, or the like. However, it should be understood that the present disclosure is not limited thereto and the first conductivity type semiconductor layer 121a may also be doped with an opposite conductivity, including p-type dopants.

In addition, the first conductivity type semiconductor layer 121a may be composed a single layer or multiple layers. Furthermore, the first conductivity type semiconductor layer 121a may further include a contact layer, a modulation doping layer, an electron implantation layer, and the like.

The active layer 121b is a light emitting layer formed on the first conductivity type semiconductor layer 121a, may include a phosphide or nitride semiconductor, such as (Al, Ga, In)P or (Al, Ga, In)N, and may be grown on the first conductivity type semiconductor layer 121a by techniques, such as MOCVD, MBE, or HVPE.

In addition, the active layer 121b may include a quantum-well structure (QW) including at least two barrier layers and at least one well layer, and may include a multi-quantum well structure (MQW) including a plurality of barrier layers and a plurality of well layers.

The wavelength of light emitted from the active layer 121b may be adjusted by controlling the composition ratio of materials constituting the well layers. In this case, the well layers may commonly have the same element, for example, In.

The second conductivity type semiconductor layer 121c may be a semiconductor layer formed on the active layer 121b.

The second conductivity type semiconductor layer 121c may include a phosphide or nitride semiconductor, such as (Al, Ga, In)P or (Al, Ga, In)N, and may be grown by techniques, such as MOCVD, MBE, or HVPE. The second conductivity type semiconductor layer 121c may be doped to become a conductivity type opposite to the first conductivity type semiconductor layer 121a. For example, the second conductivity type semiconductor layer 121c may be a p-type semiconductor layer doped with dopants, such as Mg.

The second conductivity type semiconductor layer 121c may be formed as a monolayer having a composition, such as p-GaN, without being limited thereto, and may further include an AlGaN layer.

In addition, the light emitting device may further include an electron blocking layer having a high bandgap between the second conductivity type semiconductor layer 121c and the active layer 121b. The electron blocking layer may be placed on top of the active layer 121b and may prevent electrons from overflowing from the active layer 121b to the top thereof.

In addition, the light emitting device 120 may include a lower contact layer 124, an insulating layer 125, a P electrode pad 122a, and an N electrode pad 123a that include a transparent conductive material transmitting light.

The N and P electrode pads 122a, 123b may be electrically connected to the substrate 110 through connection electrodes 122b, 123b. However, it should be understood that this embodiment is not limited thereto and the **N,** P electrode pads 122a, 123a may be soldered directly to the substrate 110 without the connection electrodes 122b, 123b.

Light emitted from the light emitting devices 120 disposed on an upper surface of the substrate 110 may have the same peak wavelength or may have different peak wavelengths from each other.

Referring to FIG. 5B, three light emitting devices 120 may be mounted side-by-side in the same plane on the substrate 110 and may emit red light, blue light, and green light to form a single pixel displaying an RGB trichromatic color.

By way of example, one of the three light emitting devices 120 constituting a pixel may be a light emitting diode emitting blue light B, that is, a blue light emitting diode having a peak wavelength within the blue wavelength region, in which the blue light emitting diode may have a difference of 2 nm and 15 nm between a peak wavelength and a dominant wavelength. Specifically, the blue light emitting diode may have a peak wavelength between 430 nm and 475 nm and a dominant wavelength between 460 nm and 480 nm. The peak wavelength of the blue light emitting diode may be shorter than the dominant wavelength thereof.

The next light emitting device among the three light emitting devices 120 constituting the one pixel P may be a light emitting diode emitting green light G, that is, a green light emitting diode having a peak wavelength within the green wavelength region, in which the green light emitting diode may have a difference of 5 nm and 20 nm between a peak wavelength and a dominant wavelength. Specifically, the green light emitting diode may have a peak wavelength between 510 nm and 540 nm and a dominant wavelength between 525 nm and 545 nm. The peak wavelength of the green light emitting diode may be shorter than the dominant wavelength thereof.

The last light emitting device of the three light emitting devices 120 constituting the one pixel P may be a light emitting diode emitting red light R, that is, a red light emitting diode having a peak wavelength within the red wavelength region, in which the red light emitting diode may have a difference of 5 nm and 30 nm between the peak wavelength and the dominant wavelength. Specifically, the red light emitting diode may have a peak wavelength between 620 nm and 640 nm and a dominant wavelength between 600 nm and 630 nm. The peak wavelength of the red light emitting diode may be a longer wavelength than the dominant wavelength thereof.

A plurality of light emitting structures 12 may be formed in an array on a substrate 11 and may be cut along scribing lines to be divided into individual light emitting devices 120, which in turn may be transferred to another substrate or tape using various transfer techniques for subsequent processes, such as packaging or modularization.

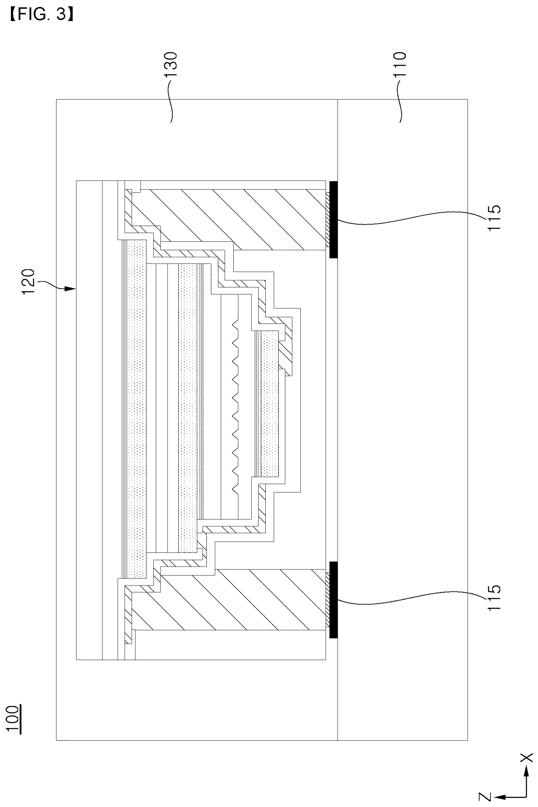

FIG. 3 is a schematic sectional view of a light emitting apparatus 100 according to one embodiment of the present disclosure. Referring to FIG. 3, the light emitting apparatus 100 includes a substrate 110, a light emitting device 120, and a molding layer 130.

The substrate 110 may include pads 115 exposed on a surface thereof and may also include interconnections connected internally or through side surfaces thereof. The substrate 110 may be formed of any material allowing the light emitting device 120 to be mounted thereon, such as a conductive circuit board, a printed circuit board, polyimide, and the like.

When the light emitting device 120 is a stacked light emitting diode as shown in FIG. 1 to FIG. 2B, the light emitting device 120 may be flip-bonded to the pads 115 through the connection electrodes 20ce, 30ce, 40ce, 50ce. A bonding agent, such as solders or solder pastes, may be used to bond the light emitting device 100 to the circuit board 110. Light generated by the first to third light emitting stacks 2, 3, 4 may be finally emitted through the substrate 110. The light emitting device 120 includes four connection electrodes 20ce, 30ce, 40ce, 50ce and thus may be connected to four pads 115 on the circuit board 110. However, the present disclosure is not limited thereto and the light emitting device 120 may be connected thereto through eutectic bonding, epoxy bonding, anisotropic conductive film (ACF) bonding, a ball grid array (BGA), or the like.

The molding layer 130 may cover at least part of a side or upper surface of the light emitting device 100 and may transmit at least a fraction of light emitted from the light emitting device 120.

The molding layer 130 may reflect, diffract and absorb a fraction of external light to prevent the external light from being reflected by the light emitting device 120 in a direction in which the light is observed by a user.

The molding layer 130 may cover at least part of the light emitting device 100 to protect the light emitting device 100 from moisture and external impact. In addition, the molding layer 130 may protect the light emitting apparatus 100 together with the protective layer 90 formed on the light emitting device 100.

The molding layer 130 may further include fillers, such as silica, TiO₂, alumina, and the like. Further, the molding layer 130 may include the same material as the protective layer 90.

The molding layer 130 may be formed by a method, such as lamination, inkjet printing, and the like. For example, the molding layer 130 may be formed by a vacuum lamination process in which an organic polymer sheet is disposed on the light emitting device 120 and subjected to high temperature and high pressure in a vacuum to provide a flat upper surface of the light emitting module, thereby improving light uniformity.

The molding layer 130 may be formed to cover both the upper surface and the side surface of the light emitting device 120. The molding layer 130 may be a transparent molding layer or may be a black matrix including a light absorption material to prevent light diffusion. Alternatively, the molding layer 130 may be free from a light absorption material in order to improve light transmittance to the outside.

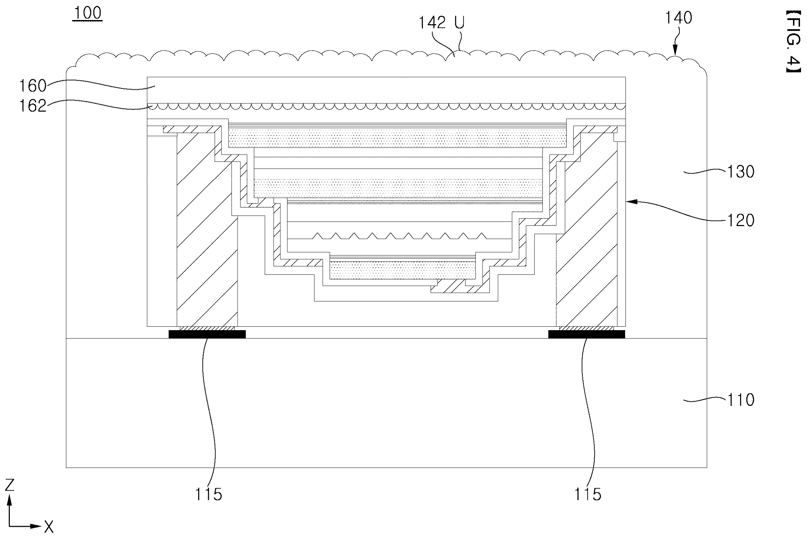

FIG. 4 is a schematic cross-sectional view of a light emitting apparatus 100 according to another embodiment. Referring to FIG. 4, the light emitting apparatus 100 may include a substrate 110, a light emitting device 120, and a molding layer 130, and may further include a first microelement 140 disposed above the light emitting device 120.

The first microelement 140 is disposed above a light exit surface of the light emitting device 120, that is, on a light emission surface, to form an optical path such that light generated by the light emitting device 120 can be emitted to the outside through the first microelement 140 disposed on the light emission surface.

The first microelement 140 may include a curved surface U formed in at least a region of at least one of upper and lower surfaces thereof. The curved surface of the first microelement 140 may be formed by a first sub-microelement 142 protruding from the upper surface thereof and FIG. 4 illustrates one example in which the curved surfaces U are formed by a plurality of first sub-microelements 142 formed on the upper surface region of the first microelement 140.

The first microelement 140 is an optical element including a curved surface U and may act as a collimator that collimates light generated by the light emitting device 120 or as a light collector that focuses light generated thereby.

The curved surface U may be a surface having a curvature formed on the surface (upper surface or lower surface) of the first microelement 140. Thus, even when light generated by the light emitting device 120 has a wide angular range, the first microelement 140 can increase an angular coverage range of light that can be effectively incident on and emitted from the first microelement 140.

The first sub-microelement 142 has a roughness structure forming the curved surface U, which may have a hemispherical shape or a conical shape. Alternatively, the roughness structure may have a truncated conical shape having a flat surface formed by cutting a distal end thereof. The structure of the first sub-microelement 142 may be selected depending on the color contrast ratio of pixels to be realized.

In one embodiment, the first microelement 140 includes a plurality of first sub-microelements 142, each of which may have a smaller width than the maximum width of the light emitting device 120. This structure allows the light emitting device 120 to receive and emit light without being affected by deviation of luminous intensity within a planar region having an area.

As light generated by the light emitting device 120 is emitted through the first microelement 140, luminous intensity of each pixel can be increased together with color contrast between pixels, thereby realizing a clear image.

On the other hand, the first microelement 140 may be integrally formed with the molding layer 130 to vertically overlap the light emitting device 120 above the light emitting device 120. The first microelement 140 may refer to an upper region integrally formed with the molding layer 130 and including an upper surface of the molding layer 130. That is, the first microelement 140 may be formed of the same material as the molding layer 130 and have the same index of refraction as the molding layer 130. No boundary may be formed between the first microelement 140 and the molding layer 130.

The first microelement 140 may further include a region extending outwards from the upper surface of the light emitting device 120 and not vertically overlapping the light emitting device 120.

Although FIG. 4 shows that the first microelement 140 is integrally formed with the molding layer 130, it should be understood that the first microelement 140 may be formed as a configuration independent of the molding layer 130.

That is, the molding layer 130 covers the upper and side surfaces of the light emitting device 120 and the first microelement 140 may be further disposed on the molding layer 130. The first microelement 140 disposed on the molding layer 130 may vertically overlap the light emitting device 120 in at least a region thereof.

Here, the first microelement 140 may be formed of the same material as the molding layer 130 or may be formed of a different material from the molding layer. Further, the first microelement 140 may have a different index of refraction than the molding layer 130. With a difference in index of refraction between the first microelement 140 and the molding layer 130, the light emitting apparatus can secure improvement in light extraction efficiency.

Further, a boundary may be formed between the first microelements 140 and the molding layer 130 and the scattering effect can be increased as primary scattering of light occurs at the boundary before light enters the first microelement 140.

The first microelements 140 may collimate or focus light emitted from the light emitting device 120 at different distances or levels depending on the shape thereof. Although light generated by the light emitting device 120 may have different luminous fluxes depending on the wavelength thereof, the first microelement 140 may have different optical path lengths, thereby enabling efficient collimation or focusing of light in the range of wavelengths (or light) providing different luminous fluxes.

The light emission surface of the light emitting device 120 may be a nitride or phosphide semiconductor layer and may be disposed to face the first microelement 140.

However, the present disclosure is not limited thereto and an additional second microelement 160 may be disposed between the nitride or phosphide semiconductor layer of the light emitting device 120 and the first microelement 140.

The second microelement 160 may be a light-transmissive layer through which light generated by the light emitting device 120 is transmitted.

The second microelement 160 may have a different index of refraction than materials of layers disposed on upper and lower surfaces thereof. In addition, the second microelement 160 may include second sub-microelements 162.

The second sub-microelements 162 may have a roughness structure similar to the first sub-microelements 142. In this embodiment, the second sub-microelements 162 may protrude or extend from the second microelement 160 in a direction in which the nitride or phosphide semiconductor layer of the light emitting device 120 is disposed (that is, toward the substrate 110).

The second microelement 160 may be formed of at least one of materials, such as sapphire, silicone, polymer, or the like, and the second sub-microelements 162 may be formed of any of sapphire, silicone, polymer, SiO₂, TiO₂, AIN, or the like.

The overall width of the second sub-microelements 162 may be different from the overall width of the first sub-microelements 142.

The overall width of the second sub-microelements 162 may be less than the overall width of the first sub-microelements 142, or vice versa. Accordingly, regions with different sharpness can be adjusted by adjusting the widths of the first and second sub-microelements 142, 162.

Furthermore, a peak-to-peak distance between vertices of adjacent first sub-microelements 142 having a roughness structure may be much smaller than the overall width of the first microelements 140, and may be smaller than a peak-to-peak distance between vertices of adjacent second sub-microelements 162 having a roughness structure.

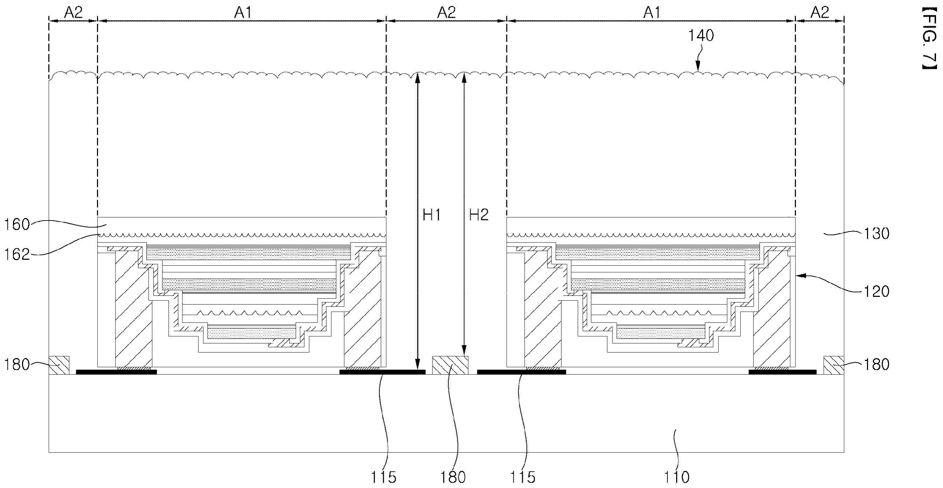

Next, FIG. 5A and FIG. 5B are sectional views of a light emitting apparatus 100 according to a further embodiment. The light emitting apparatus 100 shown in FIG. 5 may have the same or similar structure to the light emitting apparatus 100 shown in FIG. 3 and FIG. 4 except for the shape of the light emitting device 120. In other words, it will be apparent that the shape of the light emitting device 120 of the light emitting apparatus 100 is not limited to the vertically stacked structure, as shown in FIG. 3 and FIG. 4 and light emitting devices 120 shown in FIG. 7 to FIG. 12 may also be modified into the structure, as shown in FIG. 5A and FIG. 5B.

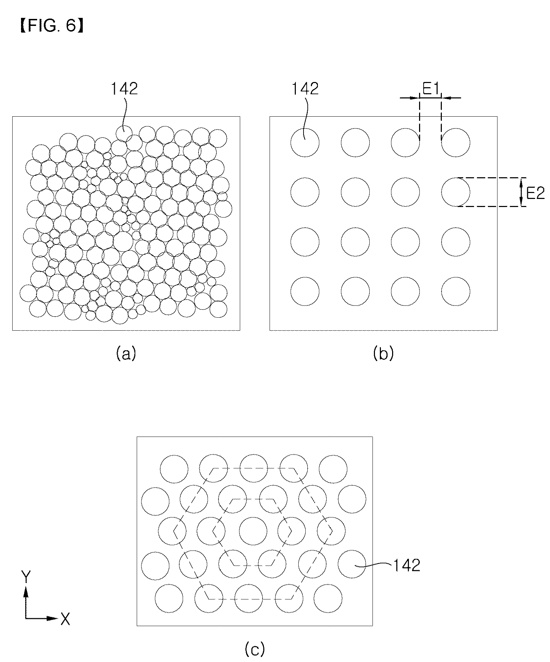

Exemplary plan views of the first microelement 140 are shown in FIG. 6A to FIG. 6C.

Referring to FIG. 6A, the upper surface of the first microelement 140 may include a plurality of first sub-microelements 142 having different heights or different sizes. Further, the plurality of first sub-microelements 142 may be interconnected to constitute one group.

Thus, light passing through the first sub-microelements 142 in one group may have different peak wavelengths. The first sub-microelements 142 in one group may be formed inside an outer boundary of the light emitting apparatus 100. That is, an upper surface of the light emitting apparatus 100 may be surrounded by a relatively flat region in which the first sub-microelements 142 are not formed.

A region surrounded by the flat region (i.e., a region where the first sub-microelements 142 are formed) may also be defined as a region where light is collimated or focused.

In addition, when the light emitting apparatus 100 includes the second microelement 160, the first sub-microelements 142 and the second sub-microelements 162 may have different sizes. Accordingly, light extraction efficiency and collimation or focusing efficiency can be improved due to the sub-microelements 142, 162 having different sizes and disposed at different levels.

Alternatively, the plurality of first sub-microelements 142 may be regularly arranged in rows m and columns n, as shown in FIG. 6B. The plurality of first sub-microelements 142 may be spaced apart from one another to be independently placed and may be surrounded by a lower height surface therebetween.

The shortest distance E1 between outer surfaces of the plurality of first sub-microelements 142 may be less than the longest width E2 of the first sub-microelements 142. Thus, light emitted from the light emitting apparatus 100 through the first microelement 140 can be emitted as uniformly as possible.

When the light emitting apparatus 100 further includes the second microelement 160, the first sub-microelements 142 of the first microelement 140 may have a different size than the second sub-microelements 162 of the second microelement 160 and may be disposed in a different arrangement from the second sub-microelements 162. Accordingly, light extraction efficiency and collimation or focusing efficiency can be improved due to the first and second sub-microelements 142, 162 disposed in different arrangements and at different levels.

In another embodiment, referring to FIG. 6C, a plurality of first sub-microelements 142 may be arranged such that a single first sub-microelement 142 is surrounded by multiple first sub-microelements 142 spaced apart from one another. In this embodiment, the plurality of first sub-microelements 142 may be arranged in a hexagonal structure, such as a honeycomb structure, when viewed as a whole.

Preferably, a single first sub-microelement 142 is disposed as a core and the first sub-microelements 142 surrounding the core may form a plurality of shells (n shells, where n is a natural number greater than or equal to 2).

The number N of first sub-microelements 142 constituting the n^{th} shell may have a relationship of (nx6)-6. In top plan view of the light emitting apparatus 100, the core may be viewed as a single first sub-microelement 142 disposed at a central point of diagonal lines and the shell may be viewed as a plurality of first sub-microelements 142 surrounding the core.

When the light emitting apparatus 100 further includes the second microelement 160, the first sub-microelement 142 and the second sub-microelement 162 may have different sizes and may be disposed substantially in the same arrangement. Accordingly, light extraction efficiency and collimation or focusing efficiency can be improved due to the first and second sub-microelements 142, 162 having similar arrangements and disposed at different levels.

Similar to FIG. 6C, one of the plurality of second sub-microelements 162 is disposed a core and the plurality of second sub-microelements 162 surrounding the core may form an n^{th} shell, where n may be 2 or more. The number N of second sub-microelements 162 constituting the n^{th} shell may have a relationship of (nx6)-6.

Next, FIG. 7 is a sectional view of a light emitting apparatus 100 according to yet another embodiment. Referring to FIG. 7, a plurality of light emitting devices 120 may be disposed on the substrate 110 to be spaced apart from each other. In this embodiment, the first microelement 140 may be formed across upper portions of the plurality of light emitting devices 120.

In addition, the light emitting apparatus 100 may further include a partition 180 disposed in a corresponding region between adjacent light emitting devices 120 on the substrate 110.

The partition 180 is a kind of partition member and may be formed of an insulating material to divide mounting regions of the plurality of light emitting devices 120. The partition 180 may also absorb at least a fraction of light. Accordingly, light generated by the light emitting device 120 may be prevented from affecting light generated by another light emitting device 120 adjacent thereto to prevent photoluminescence, thereby improving color clarity.

A region of the first microelement 140 may vertically overlap the light emitting device 120 and other regions thereof may vertically overlap the partition 180.

In the first microelement 140, when a region vertically overlapping the light emitting device 120 is referred to as A1 and the other region is referred to as A2, brightness in A1 may be adjusted to be different from brightness in A2 to improve sharpness contrast. The intensity of light emitted from the region A1 may be higher than the intensity of light emitted from the region A2.

Referring to FIG. 7, an upper surface of the partition 180 may be disposed higher than the upper surface of the pad 115 on which the light emitting device 120 is mounted. In addition, a height H2 from the upper surface of the pad 180 to the upper surface of the first microelement 140 may be less than a height H1 from the upper surface of the pad 115 to the first microelement 140.

Although not shown in the drawings, in top plan view, the partition 180 may be disposed across the plurality of light emitting devices 120. The partition 180 may divide a region inside the light emitting apparatus 100, preferably to define pixel units. Thus, when viewed from the outside, the partition 180 may have an effect of increasing color clarity of each pixel.

In addition, the partition 180 may also be disposed at an outer periphery of the light emitting apparatus 100 to expose a side surface thereof. Alternatively, in top plan view, the partition 180 disposed at the outer periphery may be disposed to surround the upper surface of the substrate 110 so as to define the outer periphery of the light emitting apparatus 100.

Thus, the partition 180 disposed between the plurality of light emitting devices 120 may be connected to the partition 180 disposed at the outer periphery of the light emitting apparatus and the light emitting devices 120 may be disposed in openings formed in the partitions 180 in top plan view.

In another embodiment where a single light emitting device 120 is disposed, the light emitting device 120 may be disposed in an opening formed in the partition 180 in top plan view.

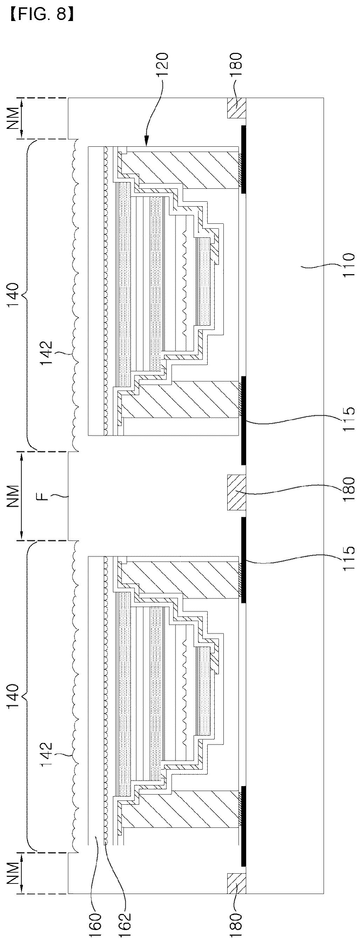

Next, FIG. 8 is a sectional view of a light emitting apparatus 100 according to yet another embodiment. Referring to FIG. 8, the first microelement 140 of the light emitting apparatus 100 may be disposed between non-micro domains (NM) in which a flat surface F is formed. In other words, the first microelement 140 may be formed continuously across the entire upper surface of the light emitting apparatus 100 as in FIG. 7, while being spaced apart from each other in each region corresponding to the upper surface of each of the light emitting devices 120.

In top plan view, the first microelement 140 may be surrounded by the non-micro domains NM. The quantity of light emitted from the non-micro domain NM may be less than the quantity of light emitted from the first microelement 140.

The non-micro domain NM may be flatter than regions formed with the first microelement 140.

That is, a height deviation of the non-micro domains NM may be less than a height deviation of the regions formed with the first microelement 140. Accordingly, since the non-micro domains NM allow re-incidence or extinction of light through total reflection of a higher quantity of light incident on the non-micro domains NM than the regions formed with the first microelement 140, the regions formed with the first microelement 140 can relatively improve clarity of light emitted therethrough

An upper surface of the region formed with the first microelement 140 may be lower than the upper surface of the non-micro domain NM. Thus, a side surface of the non-micro domain NM may act as an assistant light guide. Here, a boundary surface between the non-micro domain NM and the first microelement 140 may be formed as an inclined surface.

When the light emitting apparatus 100 further includes the partition 180, the non-micro domain NM may vertically overlap the partition 180 in at least a region thereof. Thus, light reentering the non-micro domain NM through total reflection may be scattered by the partition 180 to reduce luminance of light emitted from the non-micro domain NM, thereby increasing color contrast with respect to the region formed with the first microelement 140.

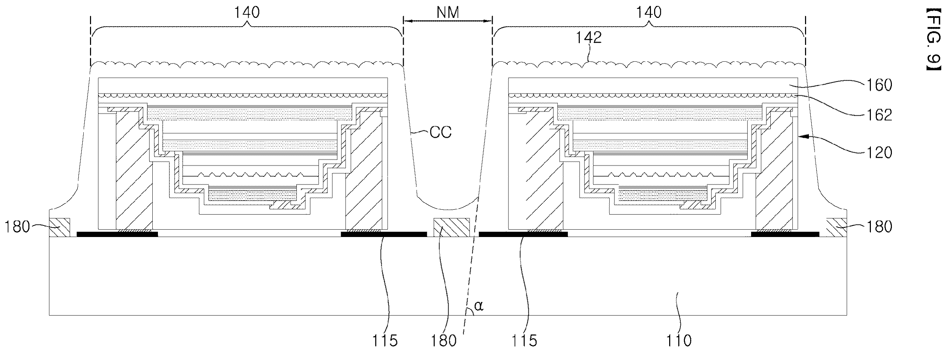

Next, FIG. 9 is a sectional view of a light emitting apparatus 100 according to yet another embodiment. Referring to FIG. 9, the first microelement 140 of the light emitting apparatus 100 may be disposed higher than the upper surface of the non-micro domain NM in a region between the light emitting devices 120. Accordingly, the region formed with the first microelement 140 becomes closer to the eye of a user, thereby improving visibility of emitted light.

In addition, a concave surface CC may be formed in a region between adjacent light emitting devices 120 to face the upper surface of the substrate 110. The concave surface CC is a recessed surface formed in the non-micro domain NM and may have a variable width along a depth thereof.

Preferably, the concave surface CC has a greater width at an upper portion thereof than at a lower portion thereof. With the variable width of the concave surface CC depending on the depth, the quantity of light emission from the non-micro domain NM may be adjusted.

A lower interface of the concave surface CC may be formed to have a curvature, thereby allowing refraction of light incident at multiple angles. A side surface of the concave surface CC (i.e., a side surface of the recessed region of the non-micro domain NM) may be tilted at an angle of 0 to 45 degrees with respect to a vertical plane of the substrate 110.

In addition, an outer surface of the light emitting apparatus 100 may be formed parallel to the side surface of the substrate 110 or a portion of the concave surface CC of the non-micro domain NM may be cut and disposed inside the substrate 110.

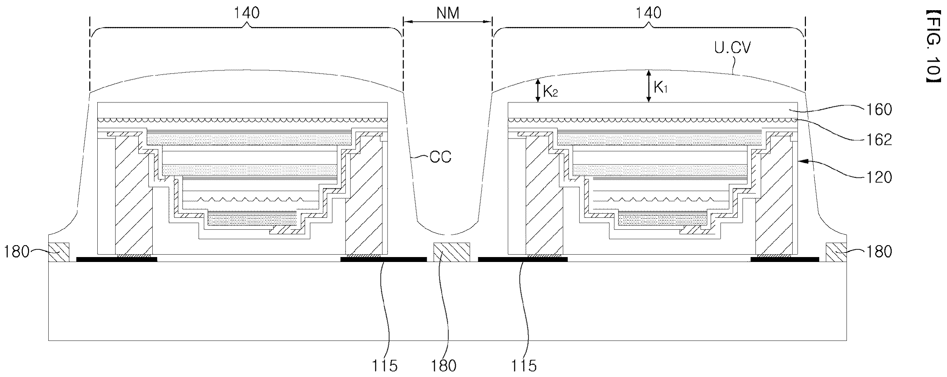

Next, FIG. 10 is a sectional view of a light emitting apparatus 100 according to yet another embodiment. Referring to FIG. 10, the curved surface U of the first microelement 140 vertically overlapping the light emitting device 120 may be a convex surface CV formed on an upper surface of the first microelement 140.

The convex surface CV has a single curvature and the first microelement 140 including the convex surface CV may have a greater width than the corresponding light emitting device 120 in a horizontal direction. Accordingly, the convex surface CV having a single curvature may extend outwards beyond the upper surface of the light emitting device 120.

With the convex surface CV, the first microelement 140 vertically overlapping the light emitting device 120 may vary in thickness depending on a location thereof.

For example, a thickness k1 of the first microelement 140 in a central region of the light emitting device 120 may be greater than a thickness K2 of the first microelement 140 in an outer peripheral region of the light emitting device.

That is, the thickness k1 of the first microelement 140 close to the central region of the light emitting device 120 may be greater than the thickness k2 of the first microelement 140 close to the outer periphery of the light emitting device 120.

The convex surface (CV, curved surface) of the first microelement 140 may extend further outwards along the side surface of the light emitting device 120 and a curvature of the upper surface of the light emitting device 120 may be different from a curvature of the side surface thereof. Thus, the width of the region guiding (or collimating or focusing) light may extend to the side surface of the light emitting device 120 while increasing color contrast.

In addition, the light emitting apparatus 100 may further include a partition 180 and the characteristics of the partition 180 may be similar to those described above and repeated description thereof will be omitted herein.

A region formed with the first microelement 140 may be disposed between the non-micro domains NM in which a concave surface CC is formed, similar to the structure shown in FIG. 9. Description of the non-micro domain NM may be similar to that described above and will be omitted herein.

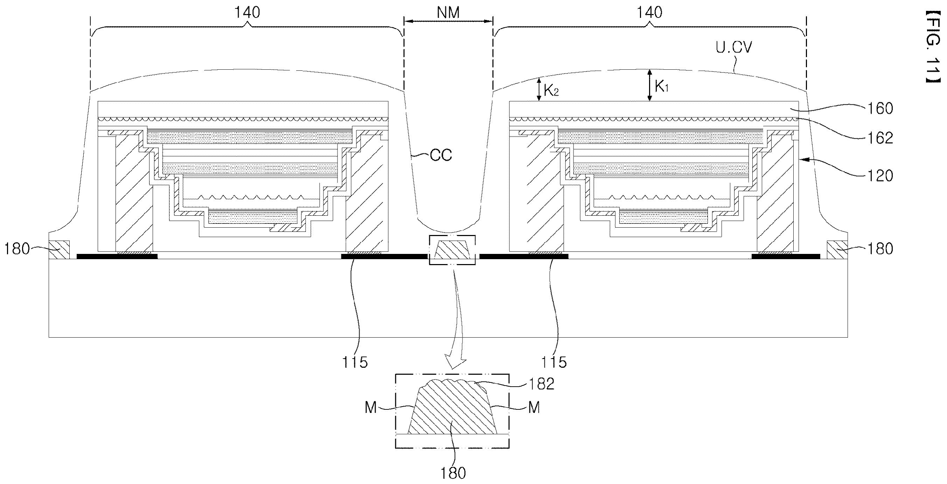

Next, FIG. 11 is a sectional view of a light emitting apparatus 100 according to yet another embodiment. The light emitting apparatus 100 of FIG. 11 may have the same or similar structure to the aforementioned embodiments except that the side surface of the partition 180 includes an inclined surface M.

The inclined surface M may be a curved surface having a curvature and may be formed with a plurality of irregularities. The inclined surface M can increase the quantity of light emitted through the upper surface of the light emitting device 120 by changing the traveling path of light incident on the side surface of the partition 180 toward the light emitting device 120, thereby improving luminance of light emitted through the first microelement 140.

As the inclined surface M is formed on the side surface of the partition 180, a distance from the side surface of the partition 180 to the light emitting device 120 may vary depending on a vertical location of the partition and a distance from the side surface of the partition 180 to at least one electrode of the light emitting device 120 may vary.

The partition 180 may be disposed between the electrodes 115 of the substrate 110. Alternatively, at least part of the partition 180 may be disposed to be spaced apart from the side surfaces of the electrodes 115 of the substrate 110 in cross-sectional view.

The upper surface of the partition 180 may include a flat surface. In another embodiment, a plurality of irregularities 182 may be formed on the upper surface of the partition 180. A region of the upper surface of the partition 180 in which the irregularities 182 are formed may be disposed to face a lower surface of the concave surface CC of the non-micro domain NM described above.

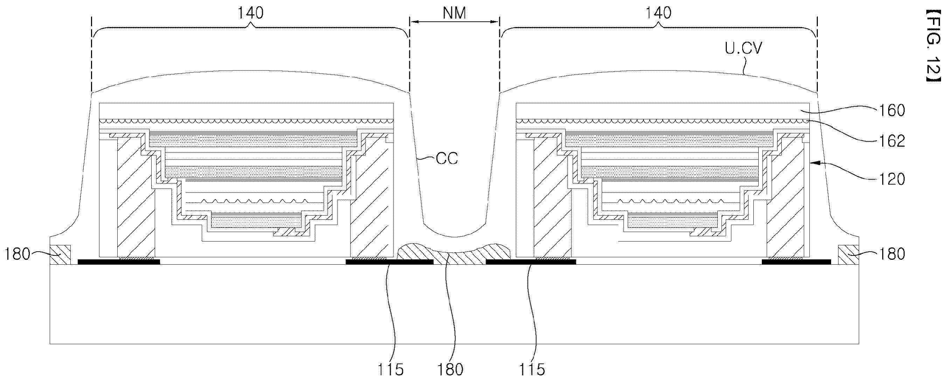

Next, FIG. 12 is a sectional view of a light emitting apparatus 100 according to yet another embodiment. The light emitting apparatus 100 shown in FIG. 12 may have the same or similar structure to the aforementioned embodiments except that the partition 180 covers at least part of the electrodes 115 of the substrate 110.

The partition 180 may be formed to cover the side surfaces of the electrodes 115 and can prevent light from being reflected from exposed upper surfaces of the electrodes 115, thereby improving color contrast between the first microelement 140 and the non-micro domain NM.

In addition, the partition 180 can prevent a conductive material from migrating to adjacent pixels or the light emitting device 120 in operation, thereby enabling effective improvement in reliability of the light emitting apparatus 100.

The upper surface of the partition 180 may be formed as a curved surface including regions with different heights and the partition 180 may be disposed to protrude upwards in a region of the partition 180 overlapping the electrode 115 such that the height of the partition 180in the region overlapping the electrode 115 is higher than the height of the partition 180 in a region not overlapping the electrode 115. By increasing the height of the partition 180 disposed close to the light emitting device 120, the quantity of light emitted into the non-micro domain NM can be reduced.

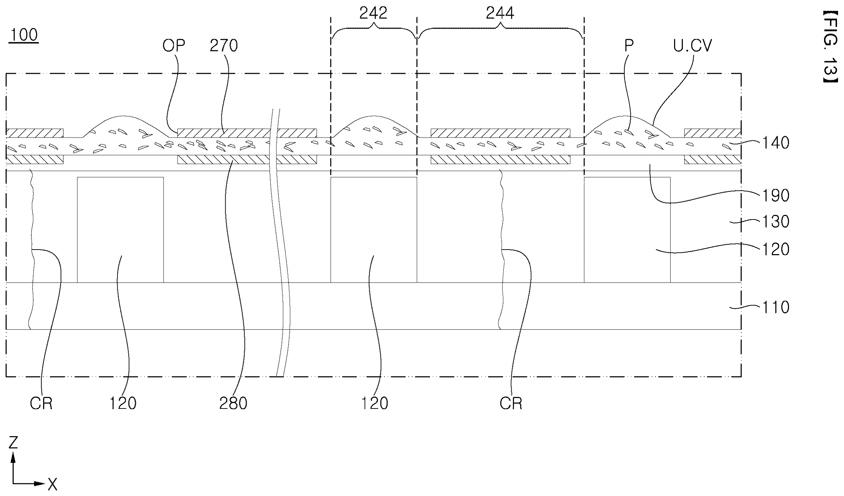

Next, FIG. 13 is a sectional view of a light emitting apparatus 100 according to yet another embodiment. Referring to FIG. 13, the light emitting apparatus 100 may include a substrate 110, at least one light emitting device 120 disposed on one surface of the substrate 110, and a molding layer 130 covering at least a region of the light emitting device 120.

The substrate 110, the light emitting device 120, and the molding layer 130 may have the same or similar structure to the aforementioned embodiments and thus detailed description thereof will be omitted.

A plurality of light emitting devices 120 may be disposed on the substrate 110 of the light emitting apparatus 100 to be spaced apart from each other and the first microelement 140 may include a plurality of guide portions 242 corresponding to upper portions of the light emitting devices 120.

At least two of the plurality of light emitting devices 120 may emit different peak wavelengths. Alternatively, each of the plurality of light emitting devices 120 may include a plurality of active layers emitting a plurality of peak wavelengths.

The curved surface U of the first microelement 140 may be formed on the guide portion 242. The light emitting apparatus 100 according to the embodiment shown in FIG. 13 may also allow light generated by the light emitting devices 120 to be emitted through the first microelement 140 disposed on the light emission surface.

The first microelement 140 may collimate or focus light particles generated in the light emitting device 120 and emitted from the light emitting device 120. As a result, luminous intensity of each pixel is increased together with color contrast between pixels, thereby a clear image.

The first microelement 140 may be formed of silicone, sapphire, glass, phenyl silicone, methyl silicone, epoxy, fused silica, borosilicate, soda-lime glass, aluminosilicate, fluoropolymer, polyphthalamide (PPA), polybutylene terephthalate (PBT), polycarbonate (PC), acryl, acryl resin, polyvinyl-butyral (PVP), polyethylene terephthalate (PET), polycyclohexylenedimethylene terephthalate (PCT), or the like.

A beam angle of light emitted through the first microelement 140 may be smaller than a beam angle of light emitted from the light emitting device 120. For example, the beam angle of light emitted from the light emitting device 120 may be greater than or equal to 120 degrees and the beam angle of light emitted through the first microelement 140 may be less than 120 degrees.

First, the guide portion 242 of the first microelement 140 forms a curved surface U. For example, the curved surface U may be a convex surface CV that protrudes or is convex in a light emission direction in cross-sectional view.

The guide portion 242 is disposed corresponding to the light emitting device 120 and may vertically overlap the light emitting device 120 in at least a region thereof.

The guide portion 242 may include a first surface through which light is emitted, and a second surface opposite the first surface and facing the light emitting device 120.

The first surface is a convex surface CV that is a curved surface U, and may have a greater curvature than the second surface. Thus, even when light generated by the light emitting device 120 has a wide angular range, the guide portion 242 can increase an angular coverage range of light that can be effectively incident on and emitted from the guide portion 242.

The guide portions 242 may have a hemispherical shape or a conical shape. Alternatively, the guide portion 242 may have a truncated conical shape having a flat surface formed by cutting a distal end thereof. The structure of the guide portion may be selected depending on the color contrast ratio of pixels to be realized.

The surface area of the first surface may be larger than the surface area of the second side. The first surface of the guide portions 242 may have a symmetrical shape on both the left and right sides with respect to a vertex disposed at the highest position. Furthermore, since the guide portion 242 includes the convex surface (CV) on the first surface thereof, the guide portion 242 may include a region that gradually becomes thinner towards both sides of the guide portion from the vertex at the highest position in the center.

Further, the width of the guide portion 242 may be less than a separation distance between the light emitting devices 120.

The first microelement 140 may further include a connecting portion 244 connecting the plurality of guide portions 242 to each another. The connecting portions 244 may be integrally formed with the guide portions 242.

The connecting portion 244 may be disposed between adjacent light emitting devices 120 to connect adjacent guide portions 242 to each other.

That is, the connecting portion 244 may be disposed between adjacent guide portions 242 and at least a region of the connecting portion 244 may be disposed between the adjacent light emitting devices 120.

The connecting portion 242 may include a first connecting surface connecting the first surfaces of the guide portions 242 to each other and a second connecting surface disposed opposite the first connecting surface and facing the substrate 110.

The first connecting surface of the connecting portion 244 may be connected to the first surfaces of the guide portions 242 and the second connecting surface of the connecting portion 244 may be connected to the second surfaces of the guide portions 242.

In cross-sectional view, the guide portion 242 may have a smaller width than the connecting portion 244. In addition, the guide portion 242 may have a greater thickness than the connecting portion 244. Further, the width of the connecting portion 244 may be less than a separation distance between the light emitting devices 120.

A first light control layer 270 may be disposed on one surface (first connecting surface) of the connecting portion 244 opposite to the substrate 110.

The first light control layer 270 is a layer disposed on the first connecting surface of the connecting portion 244 and may be disposed between the guide portions 242. In top plan view of the light emitting apparatus 100, the first light control layers 270 may be interconnected in the form of a matrix or grid pattern.

The first light control layer 270 may include openings OP each disposed corresponding to the guide portion 242 to expose the guide portions 242. The guide portions 242 may be exposed through the openings OP and the vertices of the first surfaces of the exposed guide portions 242 may be placed higher than an upper surface of the first light control layer 270. The openings OP may have a greater width than the guide portions 242.

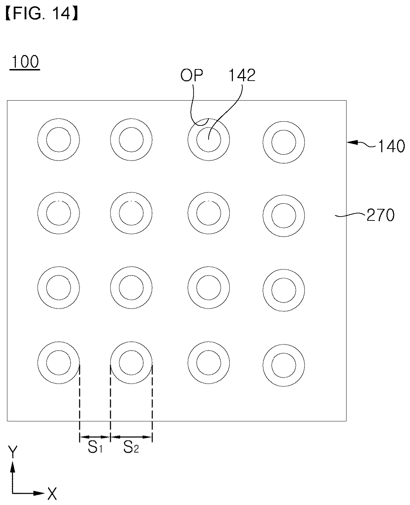

Referring to FIG. 14, in top plan view, the guide portions 242 may be regularly disposed in rows m and columns n in the form of a matrix. The plurality of guide portions 242 may be spaced apart from one another to be independently placed and may be surrounded by the first light control layer 270. A region of the connecting portion 244 may be exposed between the guide portions 242 and the openings OP in the first light control layer 270. A separation distance S1 between adjacent openings OP of the first light control layer 270 may be less than the width S2 of the opening OP.

In cross-sectional view, an edge of the upper surface of the first light control layer 270 may be disposed to horizontally overlap the side surface of the guide portion 242. That is, the edge of the upper surface of the first light control layer 270 may face the side surface of the guide portion 242. A slope of the side surface of the first light control layer 270 may be different from a slope of the side surface of the guide portion 242. Accordingly, the light emitting apparatus can achieve improvement in light extraction efficiency and can adjust the beam angle. That is, the beam angle of light emitted from the light emitting element 120 may be different from the beam angle of light emitted through the light control layer 270.

On the other hand, the first microelement 140 may include at least one type of filler P. The filler may adjust a traveling path and angle of light through scattering, refraction or absorption of the light. The filler P may include at least one of silica, SiO₂, TiO₂, alumina, carbon, or ZnO.

It should be noted that the filler P may also be added to the first microelement 140 of the light emitting apparatus 100 shown in FIG. 3 to FIG. 12.

The first microelement 140 may be disposed on an upper surface of the molding layer 130 so as to contact the molding layer 130 and may be disposed to vertically overlap at least part of the light emitting device 120 from above the light emitting device 120. The guide portions 242 of the first microelement 140 vertically overlap the light emitting devices 120. Thus, an air gap between the light emitting device 120 and the first microelement 140 can be eliminated to prevent light from being trapped in the air gap.

The first microelement 140 may be formed of an organic material, specifically a polymer material. Alternatively, the first microelement 140 may be formed of the same material as the molding layer 130 and may include a material having the same index of refraction as the molding layer 130.

Further, the first microelement 140 and the molding layer 130 may be integrally formed with each other so as to have no boundary therebetween.

The index of refraction of the first microelement 140 may be less than the index of refraction of the light emitting device 120 and may be greater than the index of refraction of an outer region. In this case, the outer region may include air. Thus, since light generated from the light emitting device 120 passes through the first microelement 140 having a lower index of refraction than the light emitting device 120 and is emitted to the outer region having a lower index of refraction than the light emitting device 120, light can be extracted outside with less loss of light

Referring now to FIG. 13, the light emitting apparatus 100 may further include a buffer layer 190 between the first microelement 140 and the molding layer 130.

The index of refraction of the buffer layer 190 may have a value between the index of refraction of the light emitting device 120 and the index of refraction of the first microelement 140. This structure can improve light extraction by reducing a difference in index of refraction between the light emitting device 120 and the first microelement 140. The buffer layer 190 may be a bonding layer that couples or bonds the first microelement 140 to the molding layer 130 or the light emitting device 120.

The light emitting apparatus 100 may further include a second light control layer 280 disposed on one surface of the substrate 110 facing the substrate 110 of the first microelement 140.

For example, the second light control layer 280 may be a layer disposed on the second connecting surface of the connecting portion 244. The second light control layer 280 may vertically overlap the first light control layer 270 in at least a region thereof. In this case, the connecting portion 244 may include at least a region in which the first light control layer 270 of the first connecting surface vertically overlaps the second light control layer 280 of the second connecting surface.

The second light control layer 280 may be a reflective layer having light reflection properties.

The second light control layer 280 may be disposed in a region between the light emitting devices 120 and prevents light generated through the side surfaces of the light emitting devices 120 from being emitted through the connecting portion 244 while reflecting the light toward the guide portions 242 such that the light can be extracted to the outside.

A lower surface of the second light control layer 280 facing the substrate 110 may be disposed higher than the upper surface of the light emitting device 120.

The light emitting apparatus 100 may include a plurality of substrates 110 disposed adjacent to each other. For example, the light emitting apparatus 100 may include first and second substrates 110 disposed adjacent to each other.

A crack line CR may be formed between the first substrate 110 and the second substrate 110 and may extend from a region between the first substrate 110 and the second substrate 110 to the molding layer 130. The first microelement 140 or the buffer layer 190 and the first microelement 140 may be disposed to cover the crack line CR.

Thus, even when light travels along the crack lines CR, the first microelement 140 can block the light from being externally observed. The crack line CR may be disposed in a region of the connecting portion 242. When the first light control layer 270 is disposed on the first connecting surface of the connecting portion 244, the crack line CR may be disposed at a lower portion of the first light control layer 270.

The structure in which the light emitting apparatus 100 includes the plurality of substrates 110 and the crack line CR is formed at the boundary between the substrates 110 may be identically or similarly applicable to the light emitting apparatuses 100 illustrated with reference to FIG. 3 to FIG. 12.

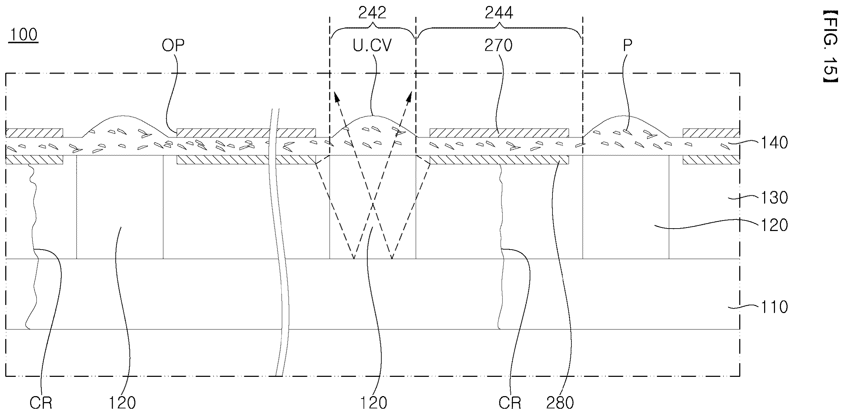

Next, FIG. 15 is a sectional view of a light emitting apparatus 100 according to yet another embodiment. Referring to FIG. 15, the light emitting apparatus 100 may have the same or similar structure to the aforementioned embodiments except that the second surface of the first microelement 140 is disposed to adjoin the molding layer 130 and the upper surface of the light emitting device 120, and thus detailed description of the repeated configuration will be omitted.

Referring to FIG. 15, the first microelement 140 may be disposed to directly adjoin the molding layer 130 and the upper surface of the light emitting device 120 without the buffer layer 190. When the light emitting apparatus 100 further includes the second light control layer 280, the lower surface of the second light control layer 280 facing the substrate 110 may be disposed lower than the upper surface of the light emitting device 120.

Accordingly, the second light control layer 280 can block and reflect light propagating from an corner of the upper surface of the light emitting device 120 to the crack line CR to prevent light from being observed at the crack line CR and can change the light path to allow the light to be emitted to the outside through the guide portions 242. That is, the traveling path of light incident on the side surface of the second light control layer 280 can be changed to a different path.

The upper surface of the second light control layer 280 may be flush with or lower than the upper surface of the light emitting device 120.

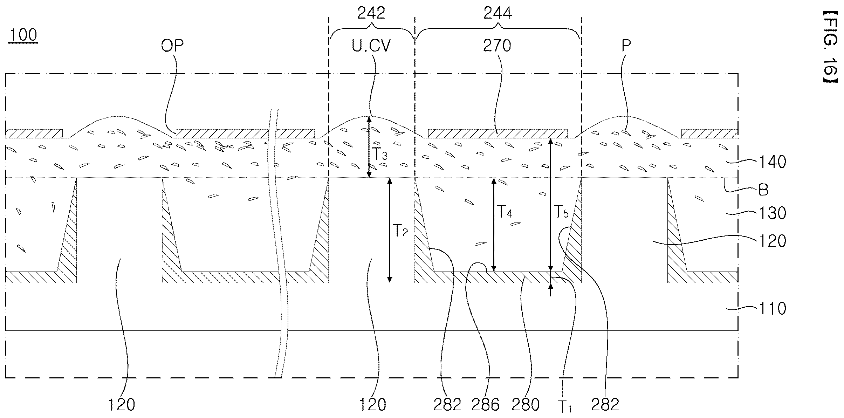

Next, FIG. 16 is a cross-sectional view of a light emitting apparatus 100 according to yet another embodiment. The light emitting apparatus 100 shown in FIG. 16 may have the same or similar structure to the aforementioned embodiments except for the location of the second light control layer 280.

Referring to FIG. 16, the second light control layer 280 of the light emitting apparatus 100 is disposed in a region between adjacent light emitting devices 120 and may adjoin the side surfaces of the light emitting devices 120.

The second light control layer 280 may include first regions 282 adjoining the side surfaces of the light emitting devices 120 and a second region 286 connected to the first regions 282 and adjoining the substrate 110.

The first regions 282 may form inclined side surfaces and the inclined side surfaces of different first regions 282 may have different slopes.

The first regions 282 may include a region having a horizontal width that is different at upper and lower portions thereof. For example, the horizontal width of the first region 282 may be gradually narrowed toward the upper portion thereof.

Further, the slope of the inclined side surface of the first region 282 may be steeper than the surface slope of the guide portion 242 of the first microelement 140.

A thickness T1 of the second region 286 may be thinner than a thickness T2 of the first region 282. Accordingly, the second light control layer 280 may form a groove when viewed as a whole, and an empty space formed by the groove may be filled by the molding layer 130 or the first microelement 140.

The sum of the maximum thickness T3 of the first microelement 140 on the upper surface of the light emitting device 120 and the height T4 from an upper surface of the second region 286 to the upper surface of the light emitting device 120 may be greater than a vertical height T5 from the upper surface of the second region 286 to the first surface of the first micro-domain 142. That is, a relationship of T3+T4>T5 may be established.

Further, the maximum thickness T3 of the guide portion 242 of the first microelement 140 may be greater than the thickness T1 of the second region 286.

The guide portions 242 of the first microelement 140 vertically overlap the light emitting devices 120 and may extend outwards to further overlap at least a region of the first region 282 of the second light control layer 280. Thus, even when the light emitting device 120 and the first microelement 140 are misaligned, the first region 282 of the second light control layer 280 vertically overlapping the guide portions 242 of the first microelement 140 can prevent the viewing angle of light from being excessively distorted.

When the light emitting apparatus 100 further includes the first light control layer 270, the first light control layer 270 may be disposed to overlap the second light control layer 280, and an opening OP boundary of the first light control layer 270 may also vertically overlap the second light control layer 280.

The first microelement 140 is a layer integrally formed with the molding layer 130 and may be formed as a single layer filling the groove formed by the second light control layer 280 and extending to the upper surface of the light emitting device 120 so as to have no boundary B therein. However, it should be understood that the present disclosure is not limited thereto.

For example, an interlayer boundary may also be formed inside the first microelement 140 and a boundary B may be formed between the groove-filling layer and a layer above the groove-filling layer. The first microelement filling the groove under the boundary B can be understood as a kind of molding layer 130. Light scattering can occur at the boundary B and light not proceeding to the guide portions 232 may be scattered at the boundary B to be dissipated.

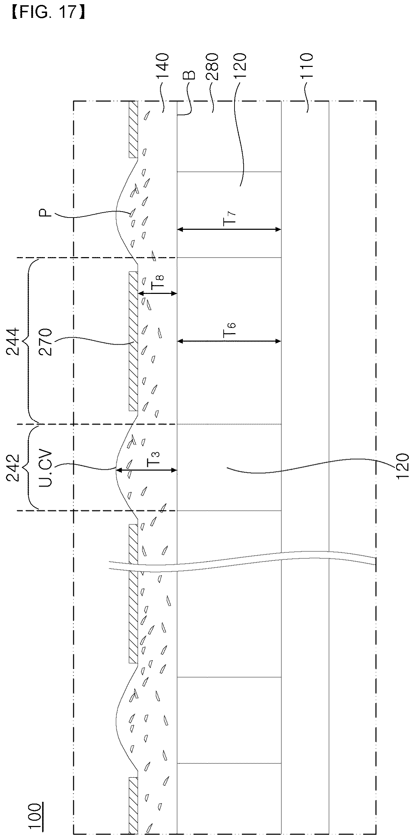

Next, FIG. 17 is a sectional view of a light emitting apparatus 100 according to yet another embodiment. The light emitting apparatus 100 shown in FIG. 17 may have the same or similar structure to the aforementioned embodiments except that the second light control layer 280 fills a space between adjacent light emitting devices 120. Referring to FIG. 17, the second light control layer 280 may act as a type of molding layer 130. The embodiment shown in FIG. 17 may also be understood as an embodiment in which the second light control layer 280 is omitted from the embodiment shown in FIG. 15.

Referring to FIG. 17, the thickness T6 of the second light control layer 280 may be less than or equal to the thickness T7 of the light emitting device 120. Further, the thickness T6 of the second light control layer 280 may range from 50% to 100% of the thickness T7 of the light emitting device 120.

The thickness T6 of the second light control layer 280 may be substantially uniform in the horizontal direction. Preferably, the thickness T6 of the second light control layer 280 disposed between at least two light emitting devices 120 has a deviation of 150 µm or less in cross-sectional view.

In top plan view, the second light control layer 280 may have an interconnected mesh shape and may be formed to surround each of the light emitting devices 120 to isolate the light emitting devices 120 from one another.

That is, a region of the light emitting device 120 may be open by the second light control layer 280 and the open region may act as a window for light emission. The thickness T6 of the second light control layer 280 may be greater than the maximum thickness T3 of the guide portions 242 of the first microelement 140.

Alternatively, the thickness T6 of the second light control layer 280 may be greater than the maximum thickness T8 of the connections 244 of the first microelement 140. However, the present disclosure is not limited thereto and the thickness T6 of the second light control layer 280 may be less than the maximum thickness T3 of the guide portions 242 or may be less than the maximum thickness T8 of the connections 244.

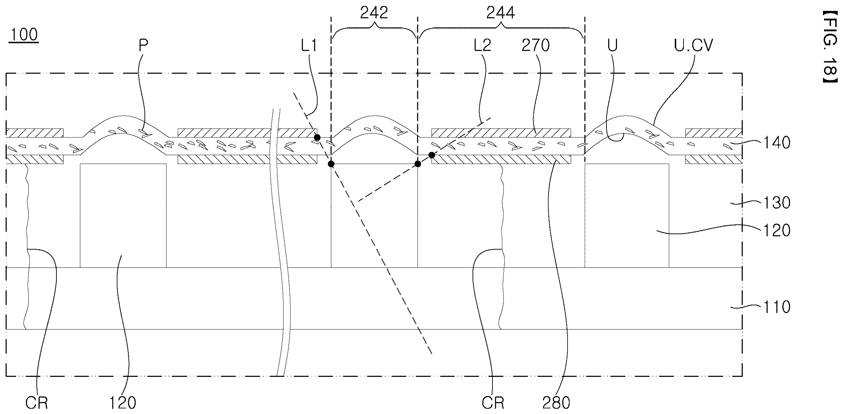

Next, FIG. 18 is a sectional view of a light emitting apparatus 100 according to yet another embodiment. Referring to FIG. 18, the light emitting apparatus 100 may have the same or similar structure to the aforementioned embodiments except for the shape of the guide portion 242 of the first microelement 140.

Referring to FIG. 18, the guide portion 242 may have curved surfaces U on upper and lower surfaces thereof. That is, the curved surfaces U may be formed on the first and second surfaces of the guide portions 242.

The first surface of the guide portion 242 of the first microelement 140 may have a convex shape CV that protrudes in the light emission direction so as to have a gradually increasing distance to the upper surface of the light emitting device 120 with deceasing distance to a central axis of the light emitting device 120.

In addition, the second surface of the guide portion 242 may also include a curved surface U that protrudes in the light emission direction so as to have a gradually increasing distance to the upper surface of the light emitting device 120 with deceasing distance to the central axis of the light emitting device 120.

As the first surface of the guide portion 242 includes the curved surface U, the first surface of the guide portion 242 may be formed with a region in which a distance between the first surface of the guide portion 242 and the upper surface of the light emitting device 120 varies.

The molding layer 130 may be further disposed in the region between the first surface of the guide portion 242 and the upper surface of the light emitting device 120 and may transmit light emitted through the upper surface of the light emitting device 120 to the guide portion 242. According to the curved shape U of the first and second surfaces of the guide portion 242, the molding layer 130 filling the region between the guide portions 242 and the upper surface of the light emitting device 120 may be formed in a convex lens shape and a boundary surface between the molding layer 130 and the guide portions 242 may also be formed in a convex shape CV.

Further, the light emitting device 120 may vertically overlap the curved surface U of the first surface of the guide portions 242. By way of example, the entirety of the light emitting device 120 may be disposed within the curved surface U region of the first surface of the guide portions 242. In another example, a portion of the light emitting device 120 may be disposed in a region of the connecting portion 244 outside the curved surface U of the guide portion 242.

Here, when an imaginary line extending from a distal end of the first light control layer 270 adjoining the first connecting surface of the connecting portion 244 to a corner of the upper surface of the light emitting device 120 is referred to as L1, an angle between L1 and the upper surface of the substrate 110 may range from 45° to 90°.

A point where the imaginary line L1 meets the upper surface of the substrate 110 may be formed within a lower surface region of the light emitting device 120.

When an imaginary line extending from a distal end of the second light control layer 280 adjoining the second connecting surface of the connecting portion 244 to a corner of the upper surface of the light emitting device 120 is referred to as L2, L2 may intersect the first light control layer 270 and L1.

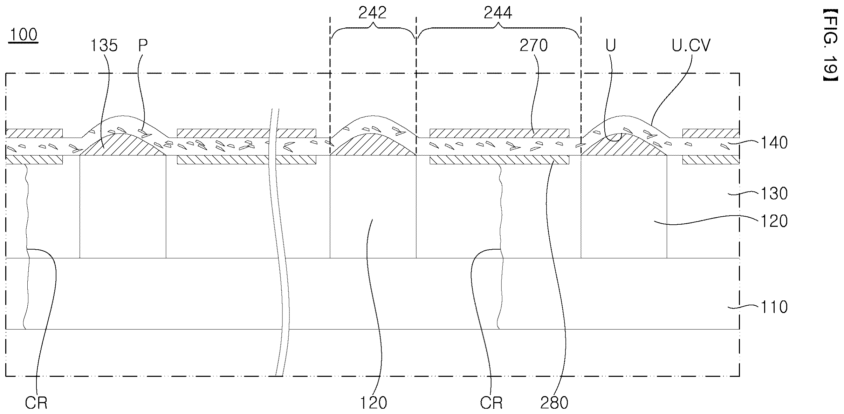

Next, FIG. 19 is a sectional view of a light emitting apparatus 100 according to yet another embodiment. The light emitting apparatus 100 shown in FIG. 19 may have the same or similar structure to the aforementioned embodiments except that the light emitting apparatus 100 further includes a collimator 135.

Referring to FIG. 19, the light emitting apparatus 100 may further include a collimator 135 disposed between the upper surface of the light emitting device 120 and the lower surface of the guide portion 242.

The collimator 135 may be disposed on the upper surface of the light emitting device 120 and may be surrounded by the second surface of the guide portion 242. In addition, the collimator 135 may be embedded by the upper surface of the light emitting device 120 and the second surface of the guide portion 242.

The collimator 135 may have a lower index of refraction than the light emitting device 120 and a difference in index of refraction therebetween may be greater than or equal to 0.9.

An upper surface of the collimator 135 may adjoin the second surface of the guide portion 242. Thus, a substance having a lower index of refraction than the collimator 135, such as air, can be prevented from being placed therebetween, thereby preventing light trapping.

The material of the collimator 135 may be the same as or different from the molding layer 130.

The collimator 135 may have a higher light transmittance than the first microelement 140 on top of the collimator 135. Accordingly, more light can be transmitted to the first microelement 140. The curvature of the upper surface of the collimator 135 may be the same as the curvature of the second surface of the guide portion 242 and may be greater than the curvature of the first surface thereof. However, the scope of the present embodiment is not limited thereto and the upper surface of the collimator 135 may have a smaller curvature than the first surface of the guide portion 242. The curvature of the upper surface of the collimator 135 may be adjusted to adjust light intensity.

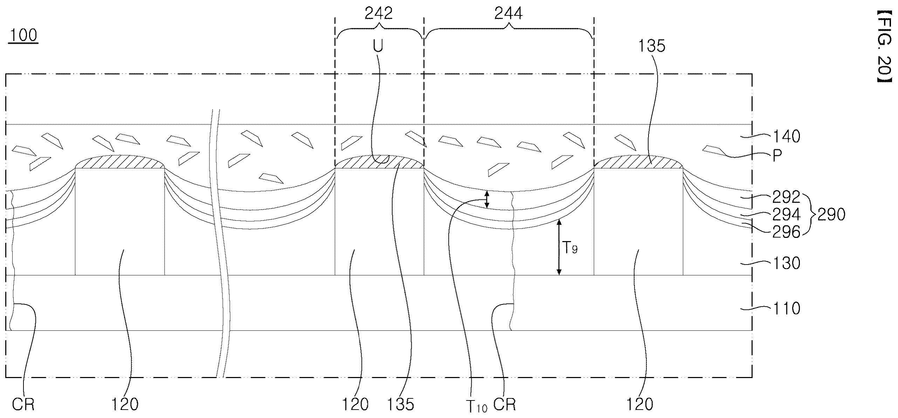

Next, FIG. 20 is a sectional view of a light emitting apparatus 100 according to yet another embodiment. The light emitting apparatus 100 of FIG. 20 may include a substrate 110, a plurality of light emitting devices 120 disposed on one surface of the substrate 110, a first microelement 140 disposed above the plurality of light emitting devices 120, and a collimator 135 disposed between the upper surface of the light emitting device 120 and the lower surface of the first microelement 140 and including a curved surface U. Repeated description of the same configuration as the aforementioned embodiments will be omitted.

Referring to FIG. 20, the upper surface (first surface) of the first microelement 140 of the light emitting apparatus 100 may be a flat surface (F). As the first microelement 140 covers the upper surface of the collimator 135, a curved surface U corresponding to the curved surface U formed on the upper surface of the collimator 135 may be formed on the second surface of the first microelement 140.

In FIG. 20, the light emitting apparatus 100 may further include a molding layer 130 covering at least part of the side surface of the light emitting device 120. The light emitting apparatus 100 may further include a third light control layer 290 disposed on the molding layer 130.

Here, the molding layer 130 is disposed in a region between the light emitting devices 120 and may have a thickness T9 gradually increasing as the distance of the molding layer to the light emitting device 120 decreases. Accordingly, the upper surface of the molding layer 130 may form a concave surface. Furthermore, the upper surface of the molding layer 130 may include regions with different slopes.

When the upper surface of the molding layer 130 forms a concave surface, the slope of the upper surface of the molding layer 130 may gradually increase with decreasing distance to the light emitting device 120. Light emitted through the side surface of the light emitting device 120 may be refracted by the surface of the molding layer 130 to be directed toward the substrate 110 and may be reflected upwards from the substrate 110 to be extracted outside.

However, the present disclosure is not necessarily limited thereto and the molding layer may have the same thickness T9 depending on the location thereof.

The third light control layer 290 may be disposed between adjacent light emitting devices 120 to be placed between the molding layer 130 and the first microelement 140. More specifically, the third light control layer 290 may be disposed below the connecting portion 244 of the first microelement 140.

The third light control layer 290 may have the same or similar characteristics as the first light control layer 270 and the second light control layer 280 described above.

For example, the third light control layer 290 may include a third-1 light control layer 292 that prevents light from being emitted between the light emitting devices 120. The third-1 light control layer 292 may have a thickness gradually decreasing towards the light emitting device 120.

As the thickness of the third-1 light control layer 290 increases, the thickness of the molding layer 130 may decrease. That is, the thickness of the third-1 light control layer 290 may be inversely proportional to the thickness of the molding layer 130. However, the present disclosure is not limited thereto and the third-1 light control layer 292 may have a uniform thickness.

The third light control layer 290 may further include a third-2 light control layer 296 disposed between the molding layer 130 and the third-1 light control layer 292. The shape and characteristics of the third-2 light control layer 296 may be similar to the shape and characteristics of the third-1 light control layer 292.

The third-2 light control layer 296 may act as a layer that prevents light from being emitted between the light emitting devices 120.

The third-2 light control layer 296 may perform an additional light blocking function to prevent heat generated during operation of the light emitting devices 120 from causing the third-1 light control layer 292 to crack and leak light.

The third light control layer 290 may further include a material layer 294 disposed between the third-1 and third-2 light control layers 292, 296.

The material layer 294 may adjoin a lower surface of the third-1 light control layer 292 and an upper surface of the third-2 light control layer 296.

The material layer 294 may include a smaller amount of light blocking material than the third-1 light control layer 292 and the third-2 light control layer 296, or may be free from the light blocking material. Thus, layers with different light transmittance may be alternately disposed between the light emitting devices 120 to effectively block light.

The thickness of the material layer 294 may gradually decrease outwards from a central portion thereof toward the light emitting device 120. As the thickness of the material layer 294 increases, the thickness of the molding layer 130 may decrease. The thickness of the material layer 294 may be inversely proportional to the thickness of the molding layer 130. However, the present disclosure is not limited thereto and the material layer 294 may be formed to a uniform thickness.

As described above, a crack line CR may be formed across the substrate 110, the molding layer 130, and the third light control layer 290 of the light emitting apparatus 100, and the first microelement 140 may cover the crack line CR.

Thus, the crack line CR may be prevented from being observed by a user when viewed from the outside. The first microelement 140 is disposed to cover the crack line CR and extends to cover the upper surface of the collimator 135.

As the light emission surface corresponding to the upper surface of the first microelement 140 is formed as a flat surface F, the first microelement 140 may have the thinnest thickness on the upper surface of the collimator 121 and the thickest thickness on the upper surface of the third light control layer 290.

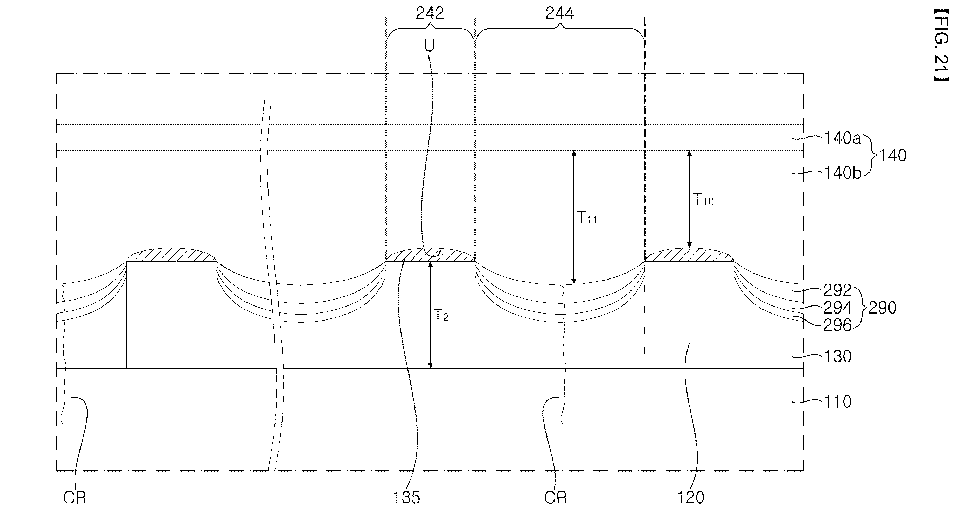

Next, FIG. 21 is a sectional view of a light emitting apparatus 100 according to yet another embodiment. The light emitting apparatus 100 shown in FIG. 21 may have the same or similar structure to the light emitting apparatus 100 shown in FIG. 20 except that the first microelement 140 is composed of a plurality of layers.

The first microelement 140 may include a first-1 microelement 140a, which covers the collimator 135 and the third light control layer 290, and a first-2 microelement 140b disposed on the first microelement 140a.

As the first-2 microelements 140b cover the upper surface of the collimator 135, a curved surface U may be formed on a lower surface of the first-2 microelement 140b, that is, at an interface of the first-2 microelement 140b with the collimator 135.

In other words, the curved surface U of the first microelement 140 may be formed on the lower surface of the first-2 microelement 140b.

An upper surface of the first-1 microelement 140a is the first surface of the first microelement 140, which is the light emission surface, and may form a flat surface F. A boundary surface between the first-1 microelement 140a and the first-2 microelement 140b may also form a flat surface F.

That is, the upper and lower surfaces of the first-1 microelement 140a may be formed parallel to each other and may be separated from the collimator 135 by the first-2 microelement 140b in the vertical direction.

A vertical separation distance T10 between the lower surface of the first-1 microelement 140a and the highest point (vertex) of the collimator 135 may be shorter than a vertical separation distance T11 between the lower surface of the first-1 microelement 140a and the third light control layer 290.

In addition, the vertical separation distance T11 between the lower surface of the first microelement 140a and the third light control layer 290 may be greater than the thickness T2 of the light emitting device 120.

Further, the vertical separation distance T10 between the lower surface of the first-1 microelement 140a and the highest height point (vertex) of the collimator 135 may be greater than the thickness of the light emitting device 120.

A cooling path for air cooling may be formed in a separation region spaced apart from the first-1 microelement 140a. When the first-2 microelement 140a fills the separation region, the first-2 microelement 140a may perform the same role as the buffer layer 190 described above.

As a buffer layer filling the separation region, the first-2 microelements 140b may be formed to cover the crack line CR.

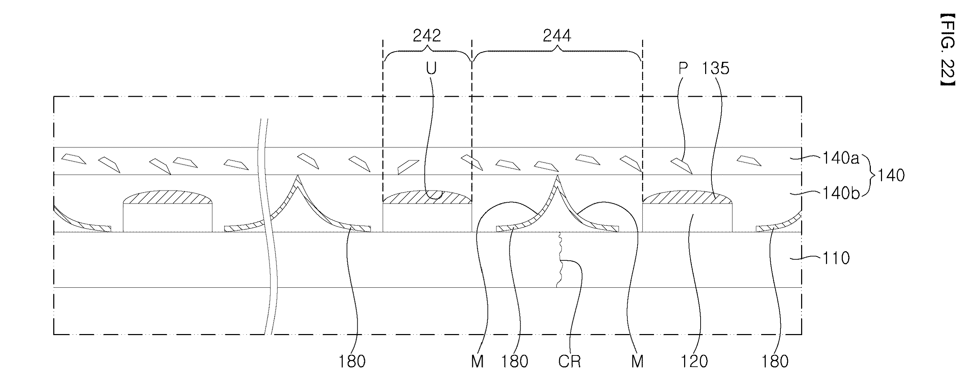

Next, FIG. 22 is a sectional view of a light emitting apparatus 100 according to yet another embodiment. The light emitting apparatus 100 shown in FIG. 22 may have the same or similar structure to the light emitting apparatus 100 shown in FIG. 21 except that the first-1 microelement 140a includes a filler P, the third light control layer 290 is omitted, and the partition 180 is disposed on the upper surface of the substrate 110.

Referring to FIG. 22, a partition 180 may be disposed between the light emitting devices 120 and at least a region of the first microelements 140a, 140b may vertical overlap the partition 180.

A side surface of the partition 180 may form an inclined surface M. Alternatively, the side surface of the partition 180 may include a curved surface.

A distance from the side surface of the partition 180 to the light emitting device 120 may vary and a distance from the side surface of the partition 180 to at least one electrode in the light emitting device 120 may vary.

Thus, brightness in a region vertically overlapping the partition 180 may be different from brightness in other regions to increase sharpness contrast.

An upper surface of the partition 180 may be disposed higher than the upper surface of the light emitting device 120. The partition 180 may be formed of an insulating material and may reflect or absorb at least a fraction of light. Thus, light generated by the light emitting device 120 may be prevented from affecting light generated by another light emitting device 120 adjacent thereto, thereby preventing photoluminescence while increasing color clarity.

The lower surface of the first-1 microelement 140a may contact at least a region of the partition 180. For example, the lower surface of the first-1 microelement 140a may contact the highest point of the partition 180. Thus, since the periphery of the light emitting device 120 is surrounded by the partition 180 and the collimator 135 and the first microelement 140 are disposed on the upper surface of the light emitting device 120, the light emitting device 120 may be isolated by the first microelement 140 and the partition 180. Thus, color contrast according to the region can be increased. However, the present disclosure is not limited thereto and the first microelement 140a may be spaced apart from the partition 180.

The connecting portion 244 of the first microelement 140 may vertically overlap the partition 180 in at least a region thereof. Thus, the traveling path of light generated by the light emitting device 120 may be changed by the partition 180 and directed toward the collimator 135.

Although not shown in the drawings, it will be apparent that the second microelement 160 described above may also be applicable to the light emitting apparatuses 100 shown in FIG. 13 to FIG. 22.

The light emitting apparatuses 100 described above may constitute a light emitting module and one or more light emitting modules may form a single display apparatus 10000.

In this embodiment, one or more light emitting devices 120 may be disposed on the substrate 110. A plurality of light emitting devices 120 may be aligned on the substrate 110.

The number of light emitting devices 120 disposed on the substrate 110 is not particularly limited to a certain number of light emitting devices. For example, the light emitting devices 120 may be arranged in a 2x2 arrangement on the substrate 110, without being limited thereto. As such, the light emitting devices 120 may be arranged in various matrices (n × m, n=1, 2, 3, 4, ..., m=1, 2, 3, 4, ...). The substrate 110 may include scan lines and data lines for independently driving each of the light emitting devices 120 in the light emitting apparatus 100.

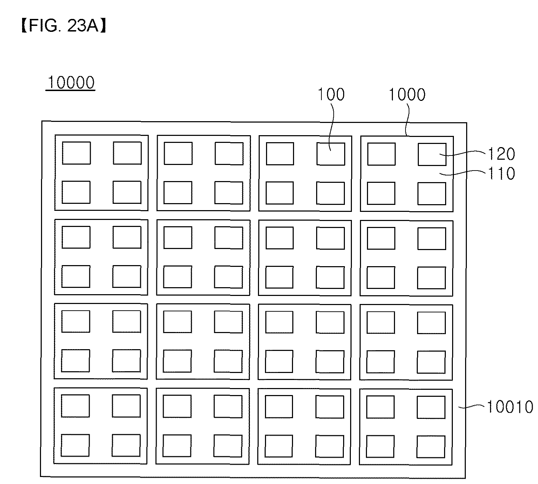

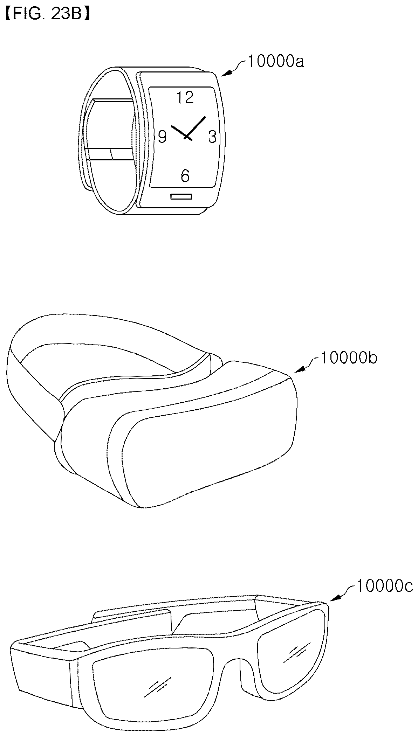

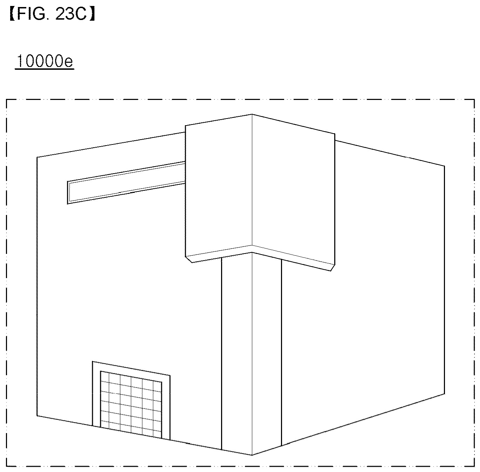

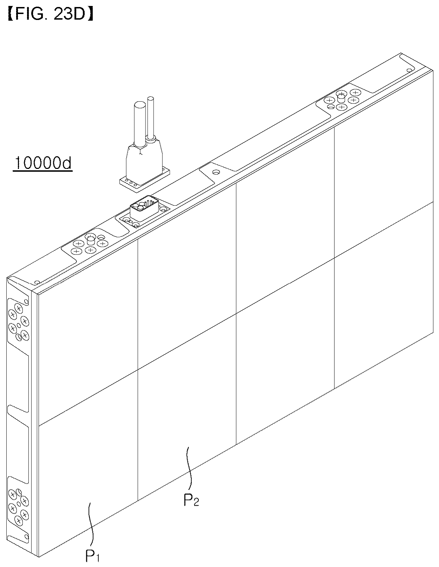

FIG. 23A to FIG. 23D are schematic perspective views of various display apparatuses 10000 according to exemplary embodiments.

Referring to FIG. 23A, a display apparatus 10000 may include a panel substrate 10010 and a plurality of pixel modules 1000. Each of the pixel modules 1000 represents a light emitting module including a plurality of light emitting apparatuses 100.

The pixel module 1000 may include a plurality of light emitting devices 120, in which at least three light emitting devices may be disposed horizontally spaced apart from each other. The plurality of light emitting devices 120 may emit light having different peak wavelengths. The pixel module 1000 may further include an auxiliary light emitting device 120 grouped with the three light emitting devices 120.

When any of the light emitting devices 120 fails to emit light, the auxiliary light emitting device 120 may be turned on instead of the light emitting device 120. In one group, the number of auxiliary light emitting devices 120 may be 25% or less of the total number of light emitting devices 120.

In another embodiment, the pixel module 1000 may include a plurality of light emitting devices 120, in which at least three light emitting layers may be vertically stacked to form a single stack of light emitting devices 120, which may emit light having different peak wavelengths.

The pixel module 10000 may further include an auxiliary light emitting device 120 grouped with the light emitting devices 120. Thus, when any of the light emitting devices 120 fails to emit light, the auxiliary light emitting device 120 may be turned on instead of the light emitting device 120. In one group, the number of auxiliary light emitting devices 120 may be 50% or less of the total number of light emitting devices 120.

The display apparatus 10000 may include a smart watch 10000a, a wearable display apparatus 10000b, such as a VR headset or glasses, an AR display apparatus 10000c, such as augmented reality glasses, indoor or outdoor display apparatuses 10000d, 10000e, such as micro-LED TVs and signboards, without being limited thereto. The panel substrate 10010 and the plurality of pixel modules 1000 may be disposed inside the display apparatus.

The panel substrate 10010 may include circuits for passive matrix driving or active matrix driving. In some embodiments, the panel substrate 10010 may include interconnections and resistors therein and in other embodiments, the panel substrate 10010 may include interconnections, transistors, and capacitors. The panel substrate 10010 may also be provided on an upper surface thereof with pads that can be electrically connected to the circuits thereon.

In one embodiment, the plurality of pixel modules 1000 is aligned on the panel substrate 10010. Each of the pixel modules 1000 may include a circuit board 110, a plurality of light emitting devices 120, and a molding layer covering the light emitting devices 100.

The smartwatch 10000a may have a brightness of 500 to 1500 cd/m² (or nits) or more and the brightness of the smartwatch 10000a may be adjusted based on external illuminance. The wearable display apparatus 10000b, such as a VR headset or glasses, may have a brightness of 150 to 200 cd/m² (or nits) or more, or may have a viewing angle of 50 degrees or more. The indoor or outdoor display apparatuses 10000d, 10000e, such as micro-LED TVs or sign boards, may have a brightness of 1,000 cd/m² (or nits) or more, or may have a viewing angle of 80 degrees or more, particularly 3,000 cd/m² (or nits) or more for outdoor use.

The display apparatuses 10000d, 10000e include a plurality of panels P1, P2 arranged in rows and columns and attached to a frame, in which each of the panels P1, P2 is provided with a plurality of micro-LED pixels, which can be turned on or off or allow light intensity to be adjusted in response to electricity supply or signals. The plurality of panels P1, P2 may be connected to an external power source through respective connectors or may be electrically connected to each other through the connectors.

Although some exemplary embodiments have been described herein with reference to the accompanying drawings, it should be understood that various modifications and changes can be made by those skilled in the art without departing from the spirit and scope of the present disclosure, as defined by the claims and equivalents thereto. Therefore, the scope of the present disclosure should not be limited to the detailed description, but limited by the accompanying claims and equivalents thereto.

## Claims

1. A light emitting apparatus (100) comprising a substrate (110), at least one light emitting device (120) disposed on one surface of the substrate (110), and a molding layer (130) covering at least a region of the light emitting device (120), and a first microelement (140) disposed above the light emitting device (120),
wherein the first microelement (140) includes a curved surface (U) formed in at least a region of at least one of an upper surface and a lower surface thereof.

2. The light emitting apparatus (100) according to claim 1, wherein the first microelement (140) is integrally formed with the molding layer (130).

3. The light emitting apparatus (100) according to claim 1, wherein an upper surface of the first microelement (140) includes a convex surface (CV).

4. The light emitting apparatus (100) according to claim 1, wherein the first microelement (140) includes a plurality of first sub-microelements (142) protruding from an upper surface thereof.

5. The light emitting apparatus (100) according to claim 1, wherein a plurality of light emitting devices (120) is disposed on the substrate (110) to be spaced apart from each other and the first microelement (140) is disposed between non-micro-domains (NM) in which a flat surface F is formed.

6. The light emitting apparatus (100) according to claim 1, wherein a plurality of light emitting devices (120) is disposed on the substrate (110) to be spaced apart from each other and a recessed concave surface (CC) is formed in a region between adjacent light emitting devices (120) to face an upper surface of the substrate (110).

7. The light emitting apparatus (100) according to claim 1, further comprising:
a partition (180) disposed in a region between adjacent light emitting devices (120) on an upper surface of the substrate (110),
wherein a plurality of light emitting devices (120) is disposed on the substrate (110) to be spaced apart from each other.

8. The light emitting apparatus (100) according to claim 7, wherein the partition (180) includes an inclined surface (M) formed on a side surface thereof.

9. The light emitting apparatus (100) according to claim 7, wherein the substrate (110) includes an electrode (115) disposed on the upper surface thereof and electrically connected to the light emitting devices (120), and the partition (180) covers a portion of the electrode (115).

10. The light emitting apparatus (100) according to claim 1, wherein the first microelement (140) includes at least one type of filler (P).

11. The light emitting apparatus (100) according to claim 1, wherein a plurality of light emitting devices (120) is disposed on the substrate (110) to be spaced apart from each other and the first microelement (140) includes a plurality of guide portions 242 corresponding to upper portions of the light emitting devices (120) and constituting the curved surface (U).

12. The light emitting apparatus (100) according to claim 11, wherein each of the guide portions (242) includes curved surfaces U formed on upper and lower surfaces thereof.

13. The light emitting apparatus (100) according to claim 11, further comprising:
a collimator (135) disposed between an upper surface of the light emitting device (120) and the lower surface of the guide portion (242).

14. The light emitting apparatus (100) according to claim 11, wherein the first microelement (140) further includes a connecting portion (244) connecting adjacent guide portions (242) to each other, and a first light control layer (270) is disposed on one surface of the connecting portion (244) opposite to the substrate (110).

15. The light emitting apparatus (100) according to claim 11, further comprising:
a buffer layer (190) disposed between the molding layer (130) and the first microelement (140).

16. The light emitting apparatus (100) according to claim 11, wherein the first microelement (140) further includes a connecting portion (244) connecting adjacent guide portions (242) to each other, and a second light control layer (280) is disposed on one surface of the connecting portion (244) at a side of the substrate (110).

17. The light emitting apparatus (100) according to claim 11, further comprising:
a second light control layer (280) adjoining a side surface of the light emitting device (120),
wherein the first microelement (140) further includes a connecting portion (244) connecting adjacent guide portions (242) to each other.

18. The light emitting apparatus (100) according to claim 11, further comprising:
a third light control layer (290) disposed between the molding layer (130) and the first microelement (140) in a region between adjacent light emitting devices (120).

19. A light emitting apparatus (100) comprising a substrate (110), a plurality of light emitting devices (120) disposed on one surface of the substrate (110), a first microelement (140) disposed above the plurality of light emitting devices (120), and light control layers (270, 280, 290) disposed between adjacent light emitting devices (120),
wherein the first microelement (140) includes a curved surface (U) formed in at least a region of at least one of upper and lower surfaces thereof.

20. A light emitting apparatus (100) comprising a substrate (110), a plurality of light emitting devices (120) disposed on one surface of the substrate (110), a first microelement (140) disposed above the plurality of light emitting devices (120), and a collimator (135) disposed between upper surfaces of the light emitting devices (120) and a lower surface of the first microelement (140) and including a curved surface (U),
wherein an upper surface of the first microelement (140) is a flat surface (F).
